# EUROPEAN PATENT APPLICATION

(11) **EP 3 605 635 A1**
(43) Date of publication of application: **05.02.2020**
(21) Application number: 18772084.2
(22) Date of filing: 23.03.2018
(51) Int. Cl.: H01L 51/50, C09K 11/06, C07D 209/86, C07D 235/08, C07D 307/77, C07D 307/91, C07D 333/58, C07D 403/14, C07D 405/12

(54) **ORGANIC ELECTROLUMINESCENCE ELEMENT AND ELECTRONIC DEVICE**

(30) Priority: 24.03.2017 JP 2017060165
(71) Applicant: Idemitsu Kosan Co., Ltd., Chiyoda-ku Tokyo 100-8321 (JP)
(72) Inventor: MASUDA, Tetsuya, Sodegaura-shi Chiba 299-0293 (JP); KAMBE, Emiko, Sodegaura-shi Chiba 299-0293 (JP); TAKAHASHI, Yoshiaki, Sodegaura-shi Chiba 299-0293 (JP)
(74) Representative: Hoffmann Eitle
(86) International application number: PCT/JP2018/011927
(87) International publication number: WO 2018/174293

(57) **Abstract**

An organic electroluminescence device, comprising an anode, an organic layer, an emitting layer, and a cathode in this order, wherein the organic layer comprises a compound represented by the following formula (20), and the emitting layer comprises a compound represented by the following formula (1).

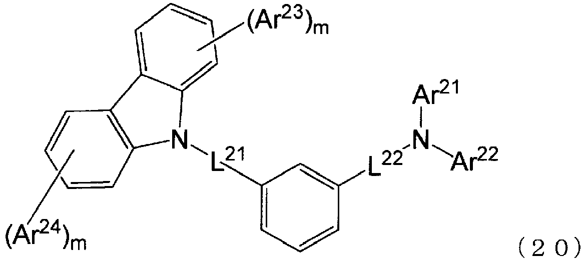

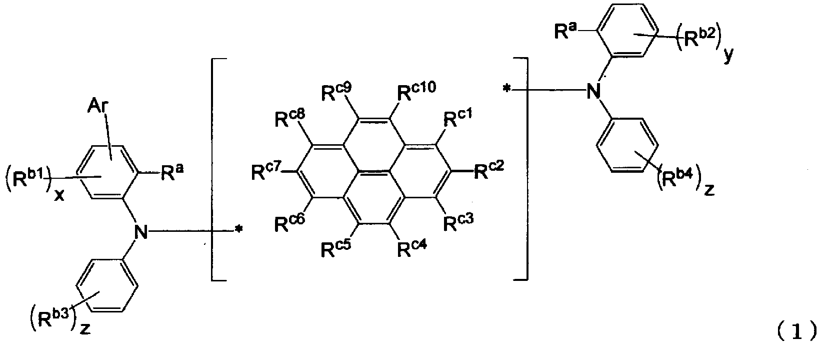

## Description

### Technical Field

The present invention relates to an organic electroluminescence device and an electronic appliance.

### Background Art

An organic electroluminescence device (may hereinafter be referred to as "an organic EL device") is expected to be used as an inexpensive large-area full-color display device that utilizes solid light-emitting, and has been developed in many cases. Generally, an organic EL device is composed of an emitting layer and a pair of counter electrodes sandwiching the layer. When an electric field is applied between the electrodes, electrons are injected from the cathode side and holes are injected from the anode side. In addition, the electrons recombine with the holes in the emitting layer to create an excited state, and energy is emitted as light when the excited state returns to the ground state.

Improvements of organic EL devices have been advanced year by year, and an organic EL device excellent in luminous efficiency is known, for example, as disclosed in Patent Document 1. However, there is a need for an organic EL device with even better performance.

### Related Art Documents

### Patent Documents

Patent Document 1: WO 2016/042781

### Summary of the Invention

The object of the present invention is provide an organic EL device having a high luminous efficiency and a long lifetime.

As a result of intensive studies by the present inventors, it has been found that an organic EL device excellent in luminous efficiency and lifetime can be obtained by using particular materials each in the emitting layer and in the organic layer positioned between the anode and the emitting layer, and the present invention has been completed.

According to an aspect of the invention, the following organic EL device and the like are provided.

An organic electroluminescence device comprising an anode, an organic layer, an emitting layer and a cathode in this order, wherein the organic layer comprises a compound represented by the following formula (20), and the emitting layer comprises a compound represented by the following formula (1): 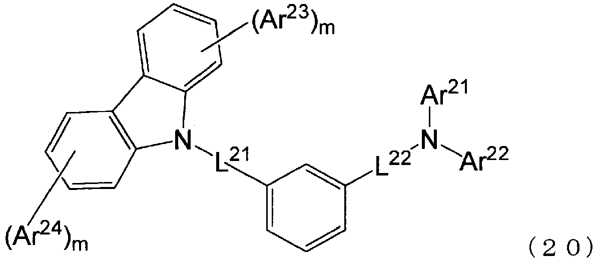
wherein in the formula (20), Ar²¹ to Ar²⁴ are independently a substituted or unsubstituted aryl group including 6 to 50 carbon atoms that form a ring (hereinafter referred to as "ring carbon atoms"), or a substituted or unsubstituted heteroaryl group including 5 to 50 atoms that form a ring (hereinafter referred to as "ring atoms"),
m is an integer of 0 to 4,
L²¹ and L²² are independently a single bond, a substituted or unsubstituted arylene group including 6 to 18 ring carbon atoms, or a substituted or unsubstituted heteroarylene group including 5 to 15 ring carbon atoms,
when m is an integer of 2 or more, plural Ar²³ may be the same or different, and plural Ar²⁴ may be the same or different; 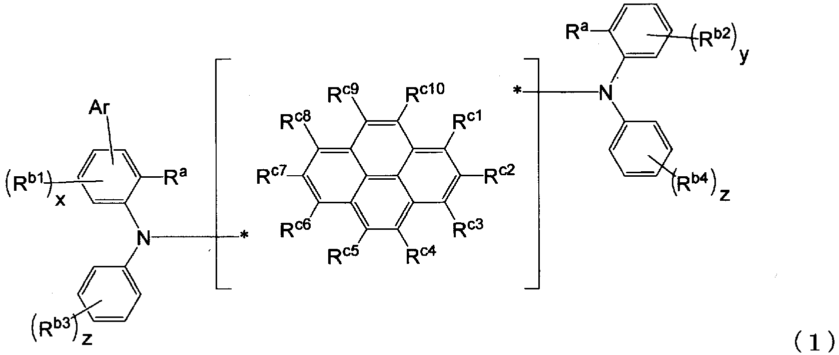
wherein in the formula (1), Ar is a substituted or unsubstituted aryl group including 6 to 30 ring carbon atoms,
R^{a} are independently a substituted or unsubstituted alkyl group including 1 to 15 carbon atoms, or a substituted or unsubstituted cyclic alkyl group including 3 to 15 carbon atoms,
R^{b1} to R^{b4} are independently a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms,
R^{c1} to R^{c10} are independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, a substituted or unsubstituted heteroaryl group including 3 to 30 ring atoms, or a single bond that bonds with a nitrogen atom,
* indicates the bonding position between a nitrogen atom and any of R^{c1} to R^{c10},
x is an integer of 0 to 3,
y is an integer of 0 to 4,
z is an integer of 0 to 5, and
when x is an integer of 2 or more, plural R^{b1} may be the same or different; when y is an integer of 2 or more, plural R^{b2} may be the same or different; when z is an integer of 2 or more, plural R^{b3} may be the same or different, and plural R^{b4} may be the same or different.

According to the present invention, it is possible to provide an organic EL device having a high luminous efficiency and a long lifetime.

### Brief Description of the Drawings

Fig. 1 is a diagram showing a schematic configuration of an embodiment of an organic EL device according to an aspect of the invention.
Fig. 2 is a diagram showing a schematic configuration of another embodiment of an organic EL device according to an aspect of the invention.

### Detailed Description of the Invention

### [Organic EL Device]

The organic EL device according to an aspect of the invention comprises an anode, an organic layer, an emitting layer, and a cathode in this order. The organic layer comprises the compound represented by the formula (20) and the emitting layer comprises the compound represented by the formula (1). The compound contained in each layer will be described later.

The organic layer comprising the compound represented by the formula (20) is positioned between the anode and the emitting layer, and is usually a hole-injecting layer or a hole-transporting layer, preferably a hole-transporting layer. The organic layer is preferably directly adjacent to the emitting layer.

The organic EL device according to an aspect of the invention may be composed of only the above layers, or may comprise other layer(s) (for example, one or more layers selected from the group consisting of a hole-injecting layer, a hole-transporting layer, an electron-injecting layer, an electron-transporting layer, and a barrier layer.

As the device configuration of the organic EL device according to an aspect of the invention, a configuration in which the following structure (1) or (2) is stacked on a substrate is exemplified.
(1) anode /hole-transporting zone/emitting layer /cathode
(2) anode /hole-transporting zone/emitting layer /electron-transporting zone /cathode
   "/" indicates that the layers are stacked directly adjacent to each other.

The hole-transporting zone is usually a zone comprising one or more layers selected from the group consisting of a hole-injecting layer and a hole-transporting layer. Each of the hole-injecting layer and the hole-transporting layer may be composed of one layer or two or more layers. Examples of the layer configuration of the hole-transporting zone include the following configurations (3) to (6).
(3) hole-transporting layer
(4) hole-injecting layer /hole-transporting layer
(5) first hole-transporting layer /second hole-transporting layer
(6) hole-injecting layer /first hole-transporting layer /second hole-transporting layer

If an organic EL device according to an aspect of the invention has any of the above configurations (3) to (6), one or more layers in each structure comprise the compound represented by the formula (20).

The electron-transporting zone is usually a zone comprising one or more layers selected from the group consisting of an electron-injecting layer and an electron-transporting layer. Each of the electron-injecting layer and electron-transporting layer may be composed of one layer or two or more layers.

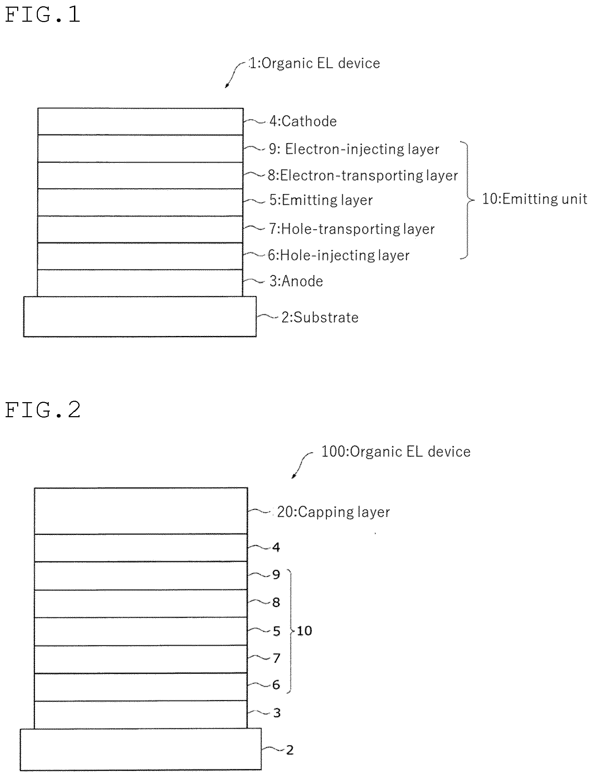

The schematic configuration of an embodiment of an organic EL device according to an aspect of the invention is shown in Fig. 1.

The organic EL device 1 comprises a light-transmitting substrate 2, an anode 3, a cathode 4, and an emitting unit 10 arranged between the anode 3 and the cathode 4. The emitting unit 10 is configured by stacking a hole-injecting layer 6, a hole-transporting layer 7, an emitting layer 5, an electron-transporting layer 8, and the electron-injecting layer 9 in this order from the anode 3. The organic EL device 1 is a bottom emission type organic EL device in which light is emitted from the substrate 2 side.

Hereinafter, each layer which is constituting the organic EL device will be described.

### (Emitting layer)

The emitting layer comprises the compound represented by the following formula (1). 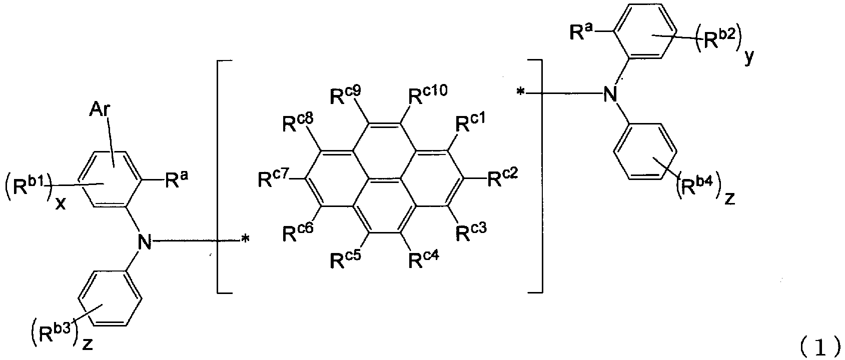
wherein in the formula (1), Ar is a substituted or unsubstituted aryl group including 6 to 30 ring carbon atoms,
R^{a} are independently a substituted or unsubstituted alkyl group including 1 to 15 carbon atoms, or a substituted or unsubstituted cyclic alkyl group including 3 to 15 carbons atoms,
R^{b1} to R^{b4} are independently a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms,
R^{c1} to R^{c10} are independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, a substituted or unsubstituted heteroaryl group including 3 to 30 ring atoms, or a single bond that bonds with a nitrogen atom.
* indicates the bonding position between a nitrogen atom and any of R^{c1} to R^{c10},
x is an integer of 0 to 3,
y is an integer of 0 to 4,
z is an integer of 0 to 5,
when x is an integer of 2 or more, plural R^{b1} may be the same or different; when y is an integer of 2 or more, plural R^{b2} may be the same or different; when z is an integer of 2 or more, plural R^{b3} may be the same or different, and plural R^{b4} may be the same or different.

The compound represented by the formula (1) is preferably represented by the following formula (2). 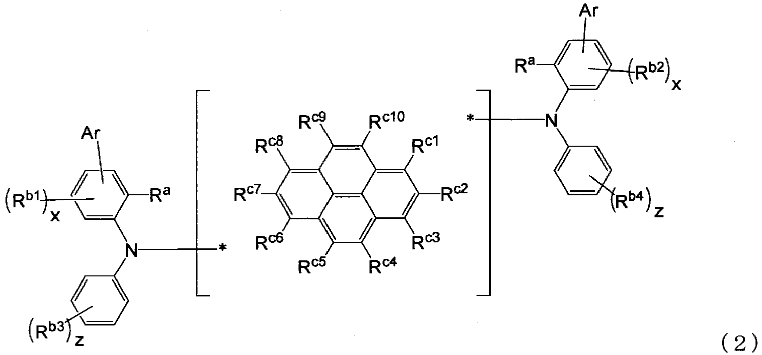 wherein in the formula (2), Ar, R^{a}, R^{b1} to R^{b4}, R^{c1} to R^{c10}, x, z and * are the same as in the formula (1).

R^{c1} to R^{c10} are preferably a group other than an arylamino group, i.e., independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, an substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted aryl group including 6 to 30 ring carbon atoms, a substituted or unsubstituted heteroaryl group including 3 to 30 ring atoms, or a single bond that bonds with a nitrogen atom.

The compound is then a disubstituted arylamino group.

The compound represented by the formula (1) is preferably represented by the following formula (3), and more preferably by the following formula (4). 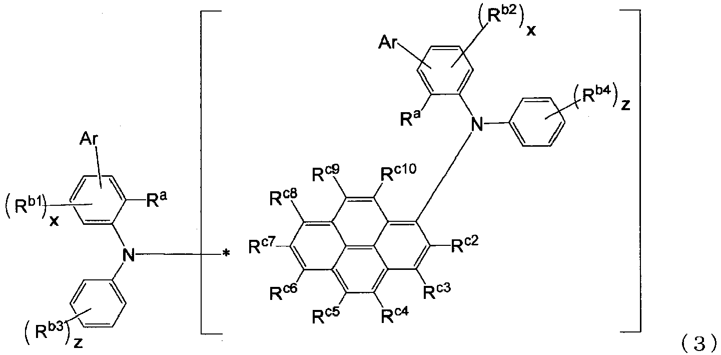 wherein in the formula (3), Ar, R^{a}, R^{b1} to R^{b4}, R^{c2} to R^{c10}, x, z, and * are the same as in the formula (1). 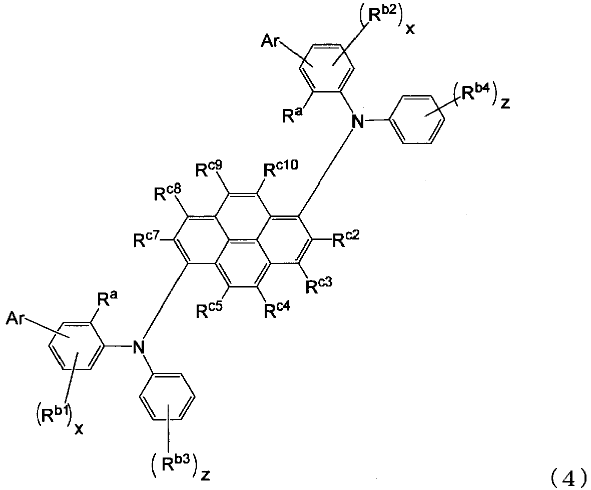 wherein in the formula (4), Ar, R^{a}, R^{b1} to R^{b4}, x and z are the same as in the formula (1).

R^{c2} to R^{c5} and R^{c7} to R^{c10} are independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms.

When the compound represented by the formula (1) is represented by the formula (4), it is more preferable to be represented by the following formula (4-1). 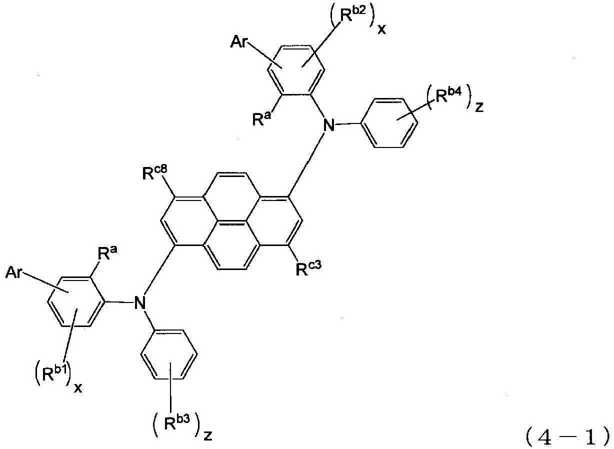 wherein in the formula (4-1), Ar, R^{a}, R^{b1} to R^{b4}, R^{c3}, R^{c8}, x, and z are the same as in the formula (4).

R^{c3} and R^{c8} are preferably independently a hydrogen atom, a alkyl group including 1 to 6 carbon atoms, or a cyclic alkyl group including 1 to 6 carbon atoms.

The compound represented by formula (1) is preferably represented by the following formula (5). 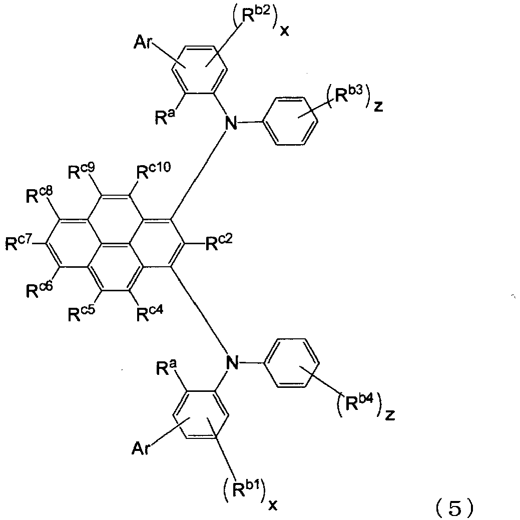 wherein in the formula (5), Ar, R^{a}, R^{b1} to R^{b4}, x, and z are the same as in the formula (1).

R^{c2} and R^{c4} to R^{c10} are independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms.

When the compound represented by the formula (1) is represented by the formula (5), it is more preferably represented by the following formula (5-1). 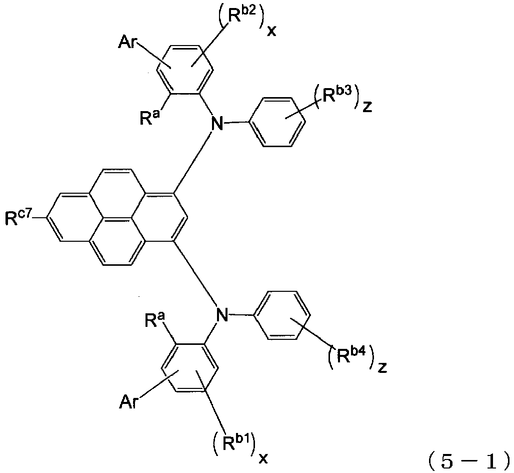 wherein in the formula (5-1), Ar, R^{a}, R^{b1} to R^{b4}, R^{c7}, x, and z are the same as in the formula (5).

R^{c7} is preferably a substituted or unsubstituted alkyl group including 1 to 15 carbon atoms, or a substituted or unsubstituted cyclic alkyl group including 3 to 15 carbon atoms.

In the formula (1), it is preferable that the benzene ring-containing group with which R^{b1} is bonded and the benzene ring-containing group with which R^{b2} is bonded have no substituent (i.e., a hydrogen atom is bonded) at the para-position with respect to the bonding position with the N atom. Specifically, it is preferable that, in the benzene ring-containing group with which R^{b1} is bonded, neither R^{b1} nor Ar be bonded at the para-position with respect to the bonding position with N atom, and in the benzene ring-containing group with which R^{b2} is bonded, R^{b2} be not bonded at the para-position with respect to the bonding position with N atom. The same applies to the formula (2) and the subsequent formulas, and it is preferable that, in the benzene ring-containing group with which R^{b1} is bonded, neither R^{b1} nor Ar be bonded at the para-position with respect to the bonding position with N atom, and in the benzene ring-containing group with which R^{b2} is bonded, neither R^{b2} nor Ar be bonded at the para-position with respect to the bonding position with N atom.

When the compound according to an aspect of the invention is used as the dopant material in the emitting layer of the organic EL device, the wavelength of emission might be lengthened by including an alkyl group or an aryl group at this position, and the blue chromaticity of the resulting emission might be lowered. Since deep blue (short-wavelength) emission is suitable for various applications of the organic EL device, it is preferable that the organic EL device have no alkyl group, aryl group, or the like at this position.

The above description does not prevent R^{b1} and Ar from being bended at the para-position, and these may be bonded at the para-position.

In the formula (1), Ar is preferably bonded with R^{a} at the para-position. Specifically, it is preferable that the benzene ring-containing group with which the R^{b1} is bonded be represented by the following formula (10), and the benzene ring-containing group with which the R^{b2} is bonded be represented by the following formula (11). By adopting this form, it is considered that the molecular arrangement of the compound represented by the formula (1) in the emitting layer is made suitable, and it is considered that more efficient emission can be realized by making the transfer of energy from the emitting layer or the like suitable when the compound is used as the dopant material in the emitting layer. 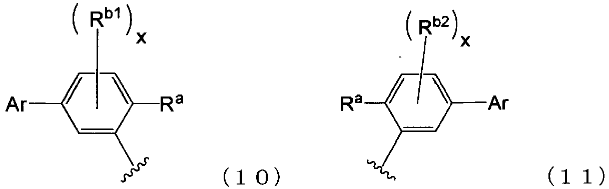 wherein in the formulas (10) and (11), Ar, R^{a}, R^{b1}, R^{b2}, and x are the same as in the formula (1).

In the formula (1), it is preferable that R^{b3} and R^{b4} do not bond at the para-position with respect to the binding position with N atom. That is, it is preferable to bond at the meta-position or the ortho-position with respect to the binding position with N atom, and it is preferable to bond at the ortho position. Specifically, it is preferable that the benzene ring-containing group with which R^{b3} is bonded be represented by the following formula (12), and the benzene ring-containing group with which R^{b4} is bonded be represented by the following formula (13). 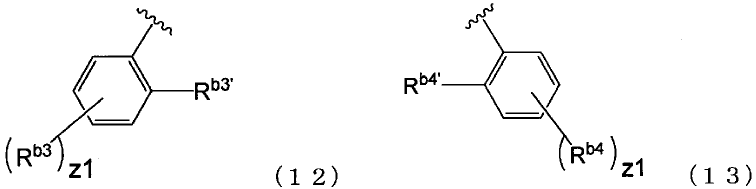 In the formulas (12) and (13), R^{b3} and R^{b4} are the same as in the formula (1).

R^{b3'} and R^{b4'} are independently a substituted or unsubstituted alkyl group including 1 to 15 carbon atoms, or a substituted or unsubstituted cyclic alkyl group including 3 to 15 carbon atoms, and z1 are independently an integer of 0 to 4.

R^{a} are preferably independently a substituted or unsubstituted alkyl group including 1 to 6 carbon atoms.

R^{b1} to R^{b4} are preferably a group other than an electron-withdrawing group, and specifically, it is preferable that R^{b1} to R^{b4} be independently a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms.

Further, it is more preferable that R^{b1} to R^{b4} be independently a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, or a substituted or unsubstituted aryl group including 6 to 30 ring carbon atoms.

It is more preferable that R^{c1} to R^{c10} be independently a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, and it is more preferable that R^{c1} to R^{c10} be a substituted or unsubstituted alkyl group including 1 to 15 carbon atoms, or a substituted or unsubstituted cyclic alkyl group including 3 to 15 carbon atoms.

The compound represented by the formula (1) is preferably a compound represented by any of the following formulas.

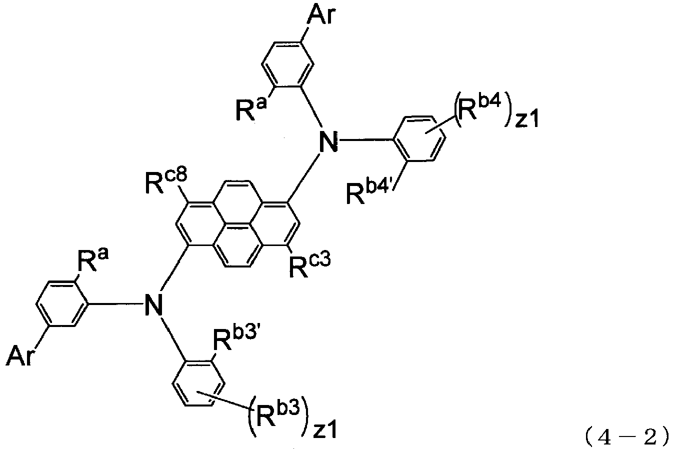

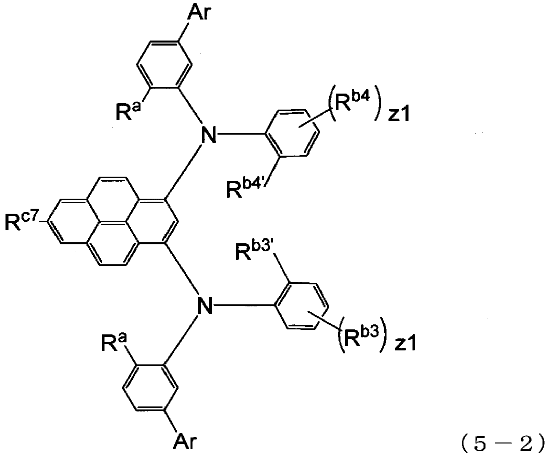

Each of the groups in the formulas (4-2) and (5-2) is as described above.

In the present specification, a hydrogen atom includes isotopes having different neutron numbers, i.e., protium, deuterium, and tritium.

In the present specification, the term "the number of ring carbon atoms" represents the number of carbon atoms among the atoms which forms a subject ring itself of a compound having a structure in which atoms are bonded in a ring form (for example, a monocyclic compound, a fused ring compound, a cross-linked compound, a carbocyclic compound or a heterocyclic compound). When the subject ring is substituted by a substituent, the carbon contained in the substituent is not included in the number of ring carbon atoms. The same shall apply to "the number of ring carbon atoms" described below, unless otherwise noted. For example, the benzene ring has 6 ring carbon atoms, the naphthalene ring has 10 ring carbon atoms, the pyridinyl group has 5 ring carbon atoms, and the furanyl group has 4 ring carbon atoms. Further, when the benzene ring or the naphthalene ring is substituted by, for example, an alkyl group as a substituent, the number of carbon atoms of the alkyl group is not included in the number of ring carbon atoms. When a fluorene ring is bonded with, for example, a fluorene ring as a substituent (including a spirofluorene ring), the number of carbon atoms of the fluorene ring as a substituent is not included in the number of ring carbon atoms.

In the present specification, the term "the number of ring atoms" represents the number of atoms which forms a subject ring itself of a compound having a structure in which atoms are bonded in a ring form (an example of the structure includes a monocyclic ring, a fused ring and a ring assembly) (an example of the compound includes a monocyclic compound, a fused ring compound, a cross-linked compound, a carbocyclic compound and a heterocyclic compound). The atoms that do not form the ring (e.g., a hydrogen atom that terminates the bond of the atoms that form the ring) or the atoms contained in a substituent where the ring is substituted by the substituent is not included in the ring atom. The same shall apply to "the number of ring atoms" described below, unless otherwise noted. For example, the pyridine ring has 6 ring atoms, the quinazoline ring has 10 ring atoms, and the furan ring has 5 ring atoms. A hydrogen atom independently bonded with a carbon atom of the pyridine ring or the quinazoline ring or an atom forming the substituent is not included in the number of ring atoms. When a fluorene ring is bonded with, for example, a fluorene ring as a substituent (including a spirofluorene ring), the number of atoms of the fluorene ring as a substituent is not included in the number of ring atoms.

In the present specification, "including XX to YY carbon atoms" in the expression "a substituted or unsubstituted ZZ group including XX to YY carbon atoms" represents the number of carbon atoms when the ZZ group is unsubstituted, and does not include the number of carbon atoms of the substituent when the ZZ group is substituted. Here, "YY" is larger than "XX", and "XX" and "YY" independently mean an integer of 1 or more.

In the present specification, "including XX to YY atoms" in the expression " a substituted or unsubstituted ZZ group including XX to YY atoms" represents the number of atoms when the ZZ group is unsubstituted, and does not include the number of atoms of the substituent when the ZZ group is substituted. Here, "YY" is larger than "XX", and "XX" and "YY" independently mean an integer of 1 or more.

The term "unsubstituted" in the context of "substituted or unsubstituted" means that there is no substitution and a hydrogen atom is bonded.

Each group represented by each of the above formulas is described in detail below.

Examples of the alkyl group include a methyl group, an ethyl group, a propyl group, an isopropyl group, an n-butyl group, a s-butyl group, an isobutyl group, a t-butyl group, an n-pentyl group, an n-hexyl group, an n-heptyl group, an n-octyl group, and the like.

The number of carbon atoms of the alkyl group is preferably 1 to 10, and more preferably 1 to 6. In particular, a methyl group, an ethyl group, a propyl group, an isopropyl group, an n-butyl group, a s-butyl group, an isobutyl group, a t-butyl group, an n-pentyl group, and an n-hexyl group are preferable.

Examples of the cyclic alkyl group include a cyclopropyl group, a cyclobutyl group, a cyclopentyl group, a cyclohexyl group, a 4-methylcyclohexyl group, an adamantyl group, a norbornyl group, and the like. The number of ring carbon atoms is preferably 3 to 10, more preferably 3 to 8, and still more preferably 5 to 8. In addition, the number of ring carbon atoms may be 3 to 6.

Examples of the aryl group include a phenyl group, a naphthyl group, an anthryl group, a phenanthryl group, a naphthacenyl group, a pyrenyl group, a chrysenyl group, a benzo[c]phenanthryl group, a benzo[g]chrysenyl group, a triphenylenyl group, a fluorenyl group, a benzofluorenyl group, a dibenzofluorenyl group, a biphenylyl group, an o-terphenyl group, a m-terphenyl group, a p-terphenyl group, a fluoranethenyl group, and the like.

The number of ring carbon atoms of the aryl group is preferably 6 to 20, and more preferably 6 to 12, and among the above aryl groups, a phenyl group and a biphenyl group are particularly preferable.

The alkylsilyl group is represented by -SiY₃, and examples of Y include each of the examples of the above alkyl groups. Examples of the alkylsilyl group include a trimethylsilyl group, a triethylsilyl group, a t-butyldimethylsilyl group, a vinyldimethylsilyl group, a propyldimethylsilyl group, a triisopropylsilyl group, and the like.

The arylsilyl group is a silyl group substituted by 1 to 3 aryl groups, and examples of the aryl group include each of the examples of the above aryl groups. In addition to the aryl group, the above alkyl group may also exist as a substituent. Examples of the arylsilyl aryl group include a triphenylsilyl group, a phenyldimethylsilyl group, and the like.

The alkoxy group is represented by -OY and examples of Y include the examples of the above alkyl groups. The alkoxy group is, for example, a methoxy group or an ethoxy group.

The aryloxy group is represented by -OZ and examples of Z include the examples of the above aryl groups. The aryloxy group is, for example, a phenoxy group.

The alkylthio group is represented by -SY and examples of Y include the examples of the above alkyl groups.

The arylthio group is represented by -SZ, and examples of Z include the examples of the above aryl groups.

The arylamino group is represented by -NZ₂ and examples of Z include the examples of the above aryl groups.

Examples of the heteroaryl group include a pyrrolyl group, a triazinyl group, a pyrazinyl group, a pyrimidinyl group, a pyridinyl group, a indolyl group, an isoindolyl group, an imidazolyl group, a furyl group, a benzofuranyl group, an isobenzofuranyl group, a dibenzofuranyl group, a dibenzothiophenyl group, a quinolyl group, an isoquinolyl group, a quinoxalinyl group, a carbazolyl group, a phenanthridinyl group, an acridinyl group, a phenanthrolinyl group, a phenazinyl group, a phenothiazinyl group, a phenoxazinyl group, an oxazolyl group, an oxadiazolyl group, a furazanyl group, a thienyl group, a benzothiophenyl group, and the like.

The number of ring atoms of the heteroaryl group is preferably 5 to 20, and more preferably 5 to 14.

The heteroaryl group is preferably a dibenzofuranyl group, a dibenzothiophenyl group, or a carbazolyl group, and more preferably a 1-dibenzofuranyl group, a 2-dibenzofuranyl group, a 3-dibenzofuranyl group, a 4-dibenzofuranyl group, a 1-dibenzothiophenyl group, a 2-dibenzothiophenyl group, a 3-dibenzothiophenyl group, or a 4-dibenzothiophenyl group.

The "carbazolyl group" includes the following structures.

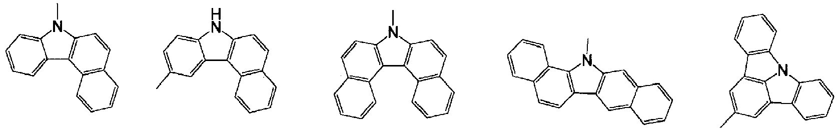

The heteroaryl group includes the following structures.

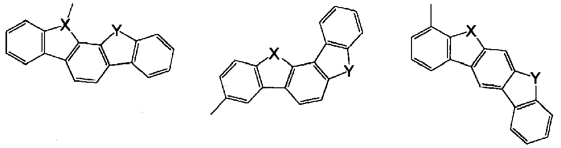

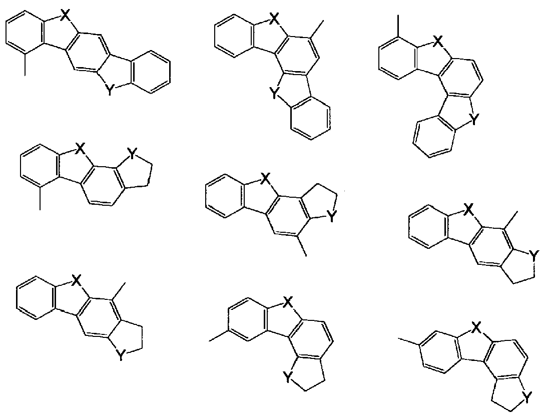

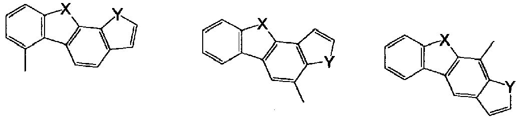

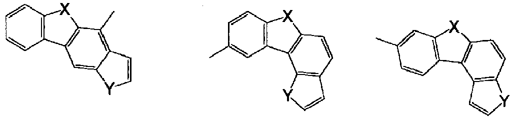

In the formulas, X and Y are independently an oxygen atom, a sulfur atom, or a -NRa-group; Ra is a hydrogen atom or a group that is the same as the R^{b1} to R^{b4}.)

Examples of the halogen atom include a fluorine, a chlorine, a bromine, and a iodine, and a fluorine atom is preferable.

The substituent in "substituted or unsubstituted..." includes those listed above.

These substituents may be further substituted by the substituent as described above. A plurality of these substituents may be bonded with each other to form a ring.

The compound represented by the formula (1) can be synthesized by known methods. Examples of the compound represented by the formula (1) are shown below.

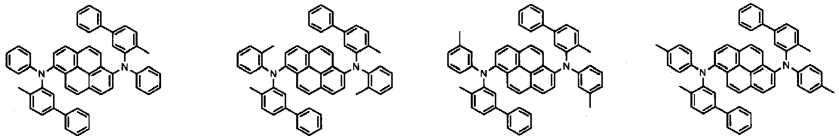

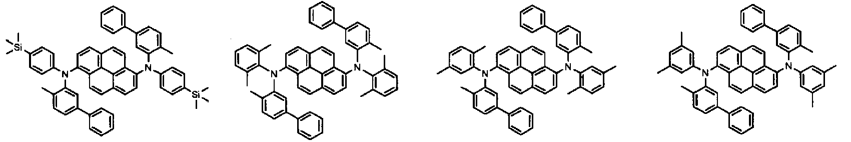

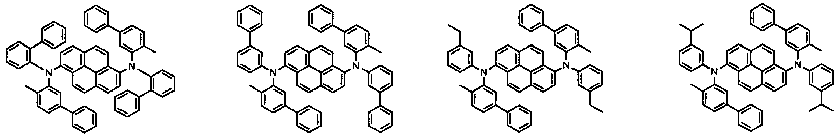

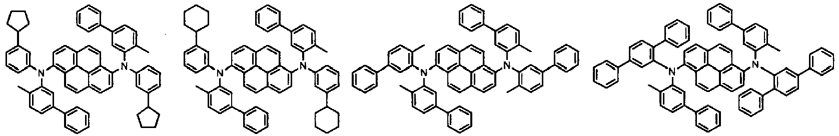

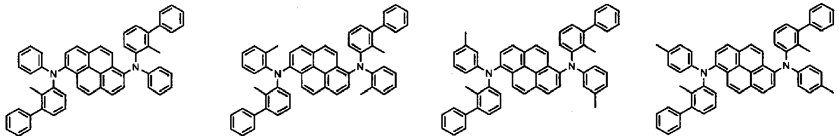

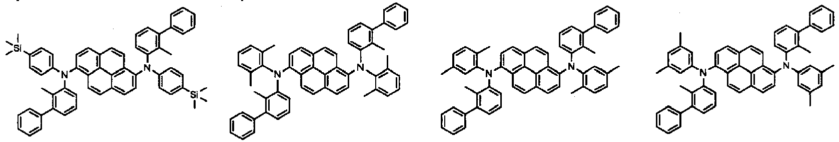

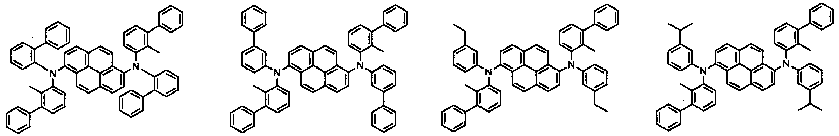

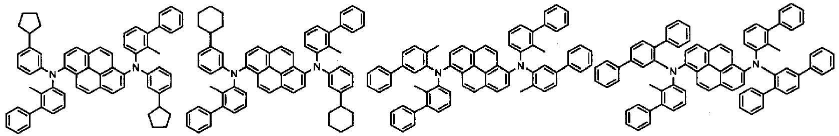

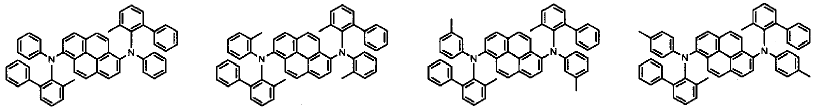

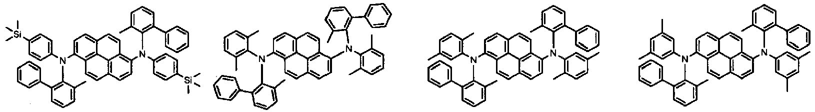

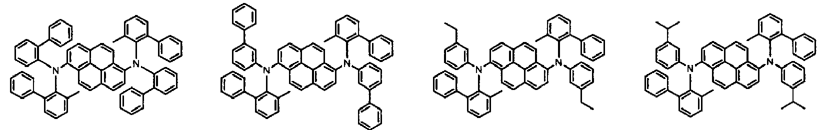

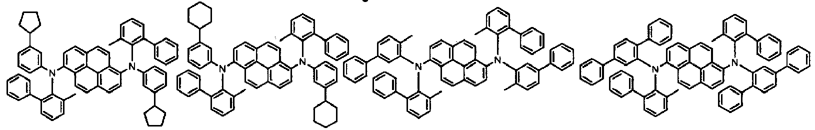

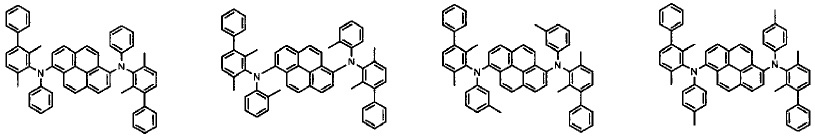

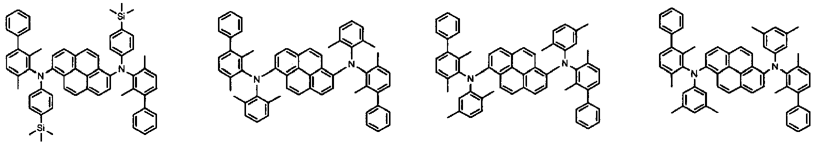

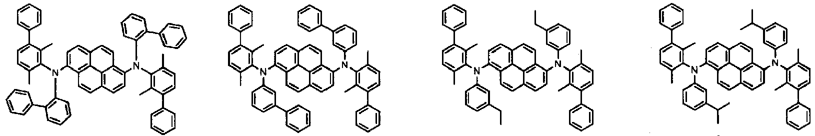

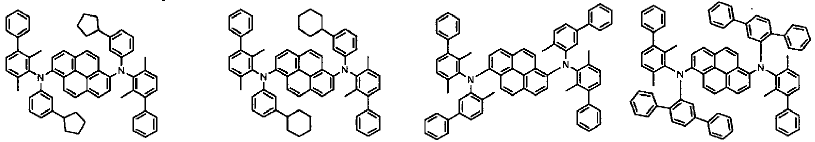

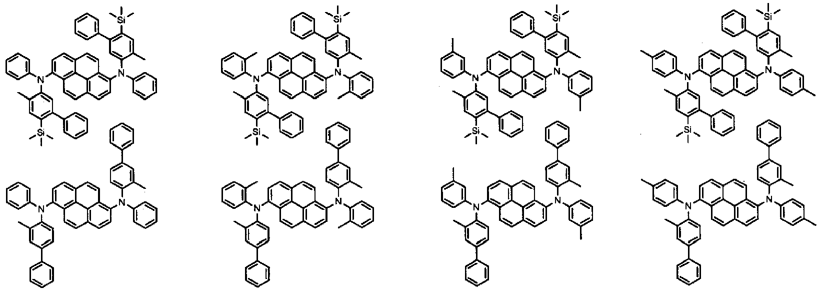

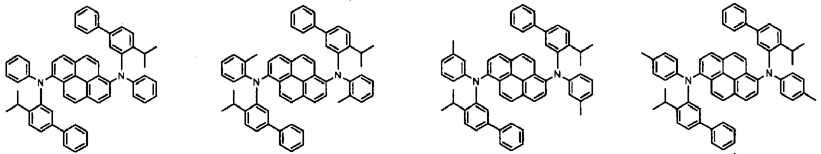

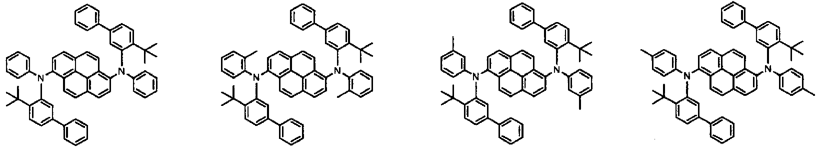

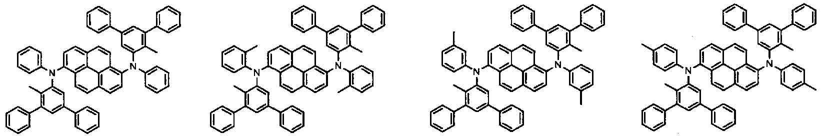

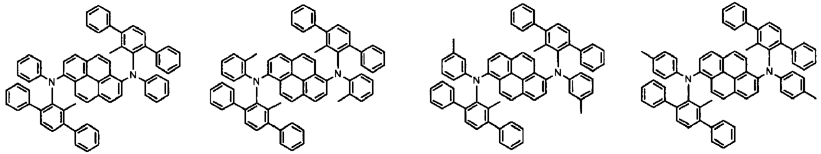

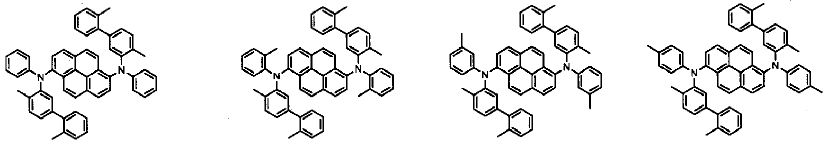

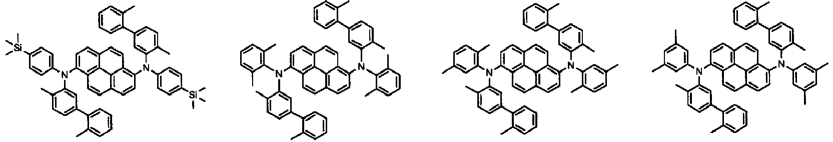

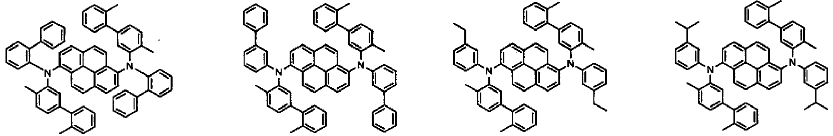

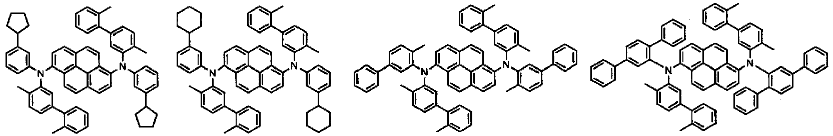

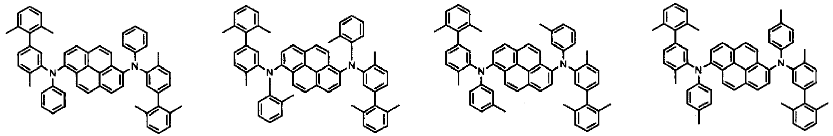

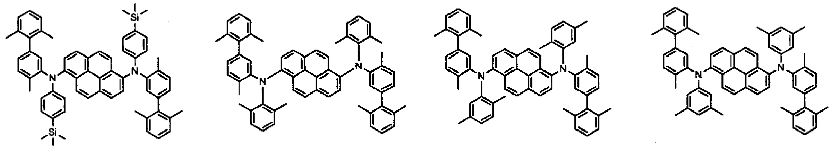

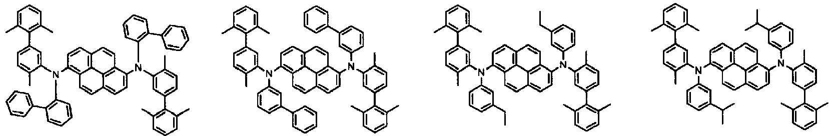

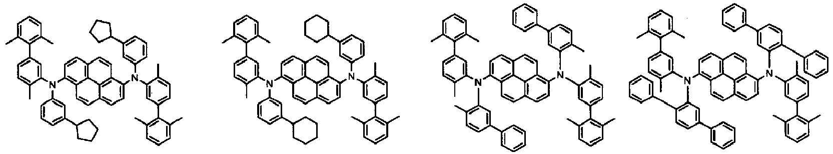

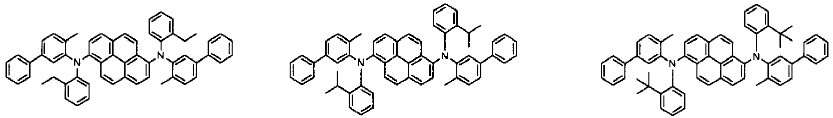

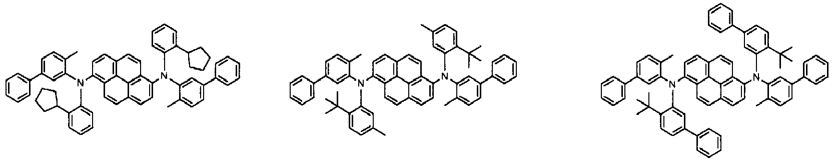

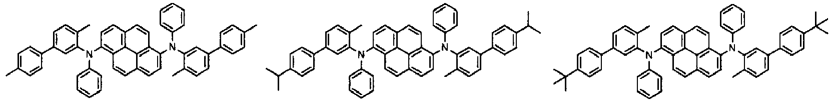

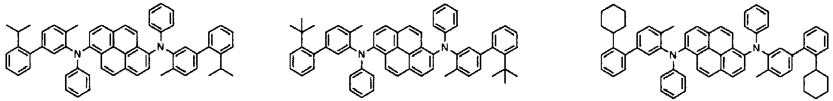

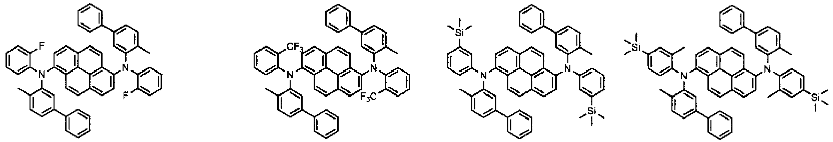

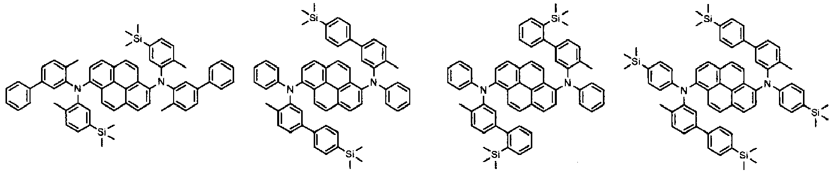

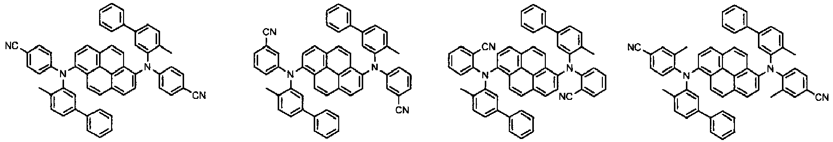

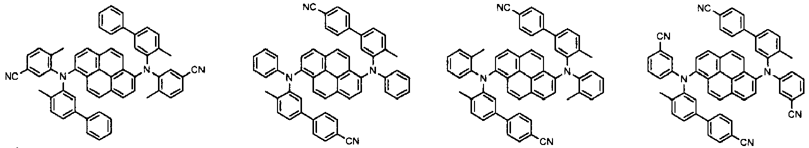

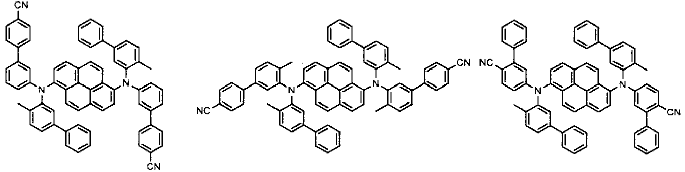

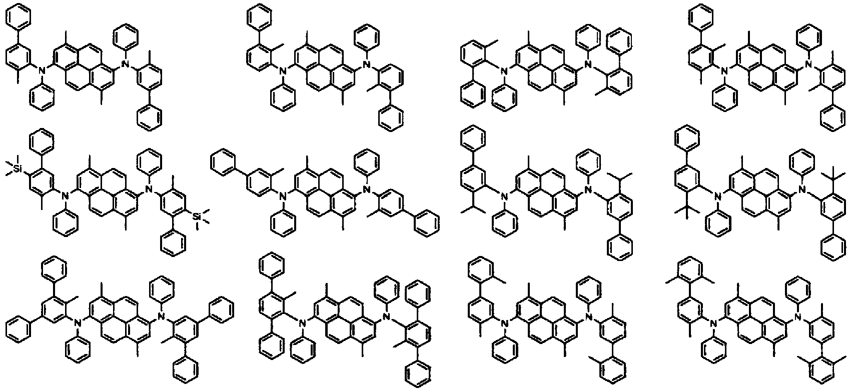

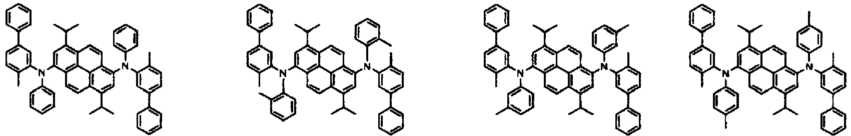

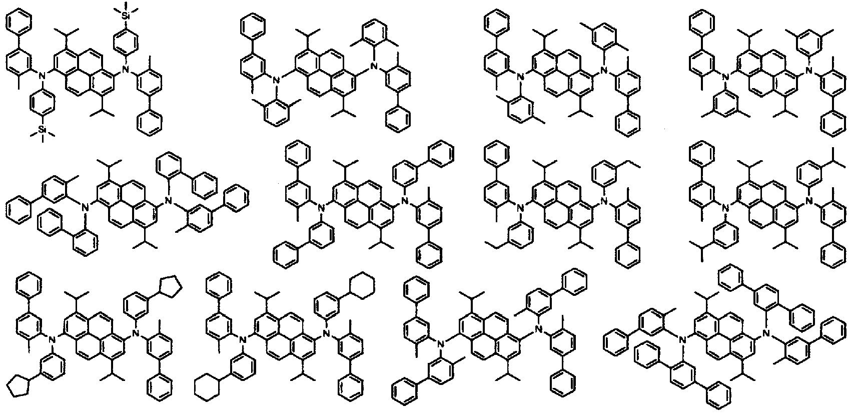

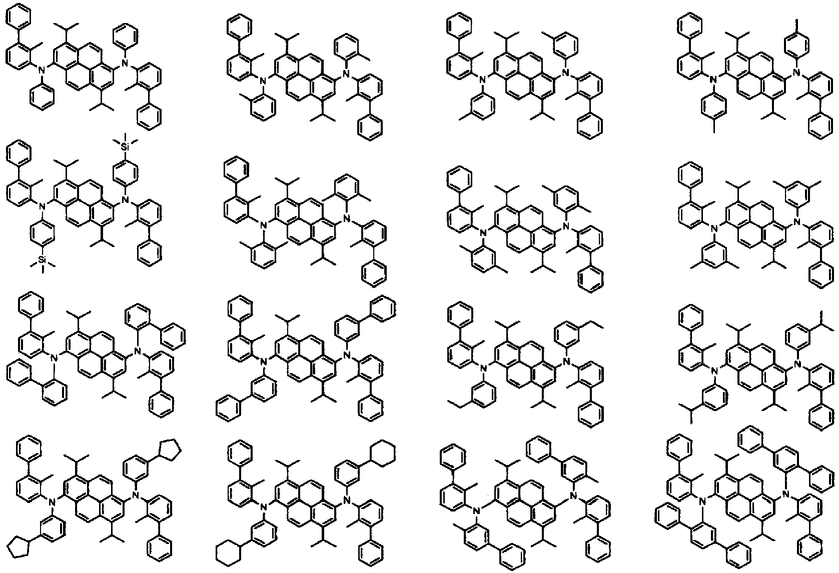

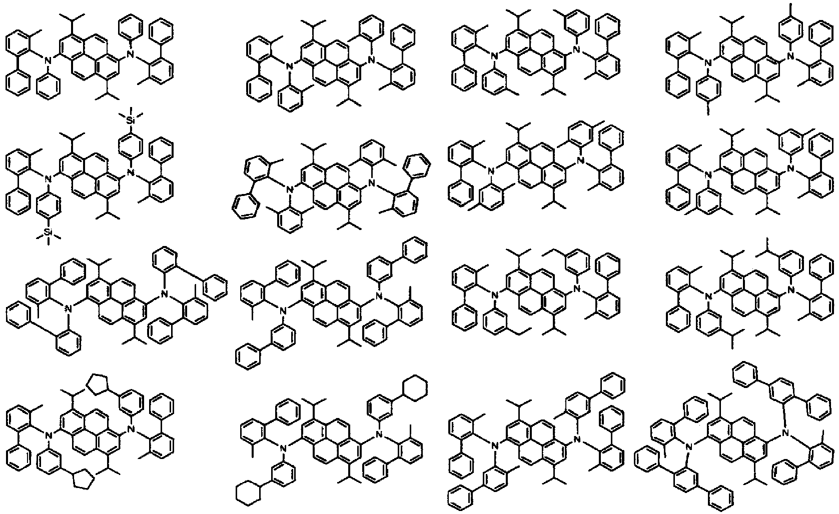

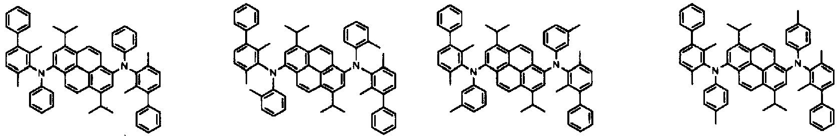

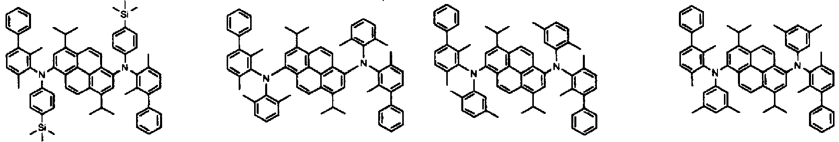

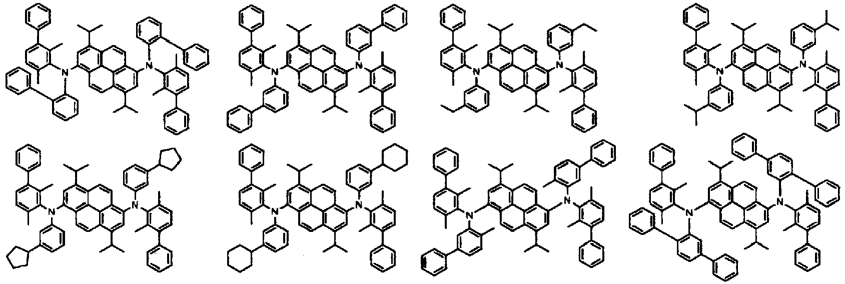

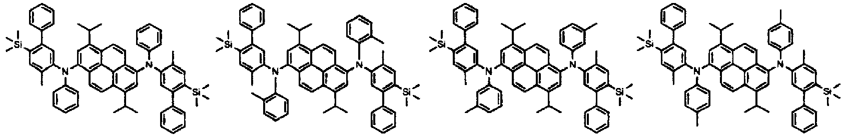

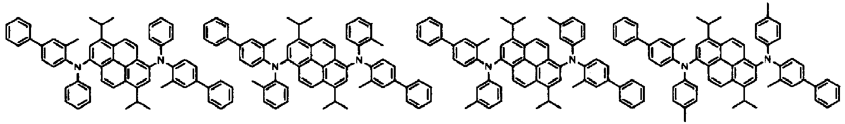

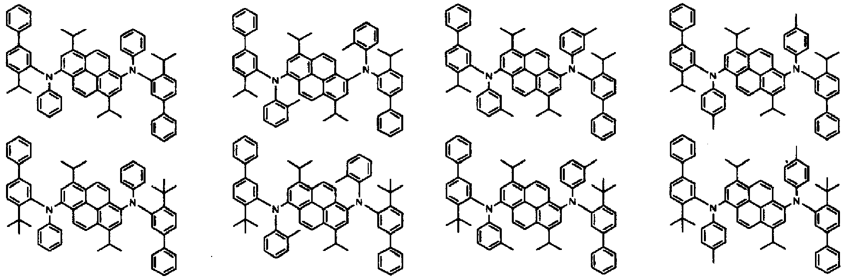

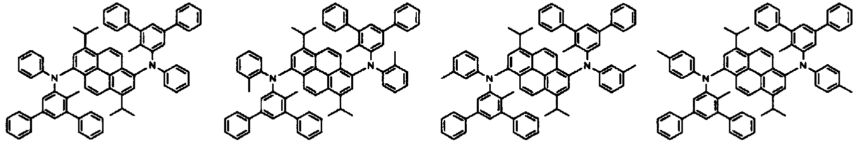

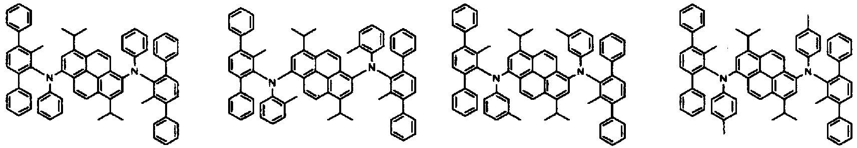

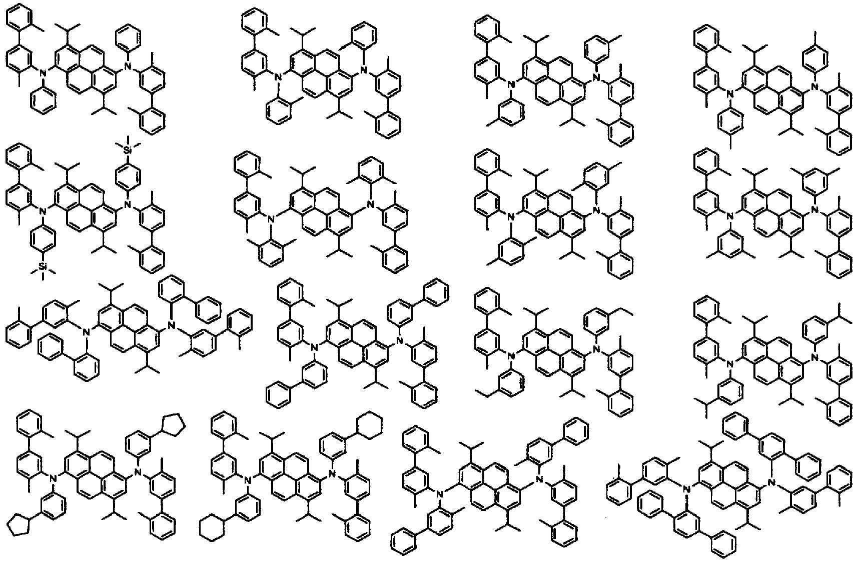

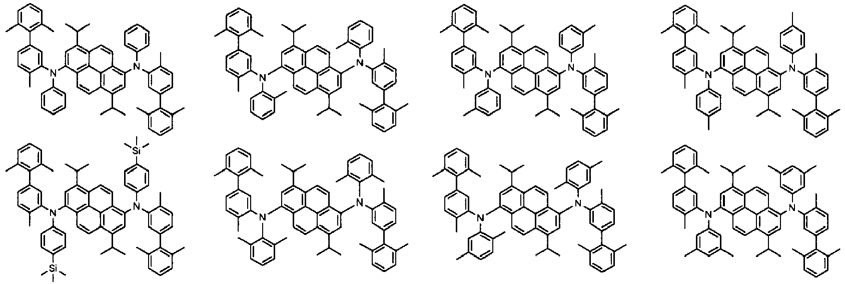

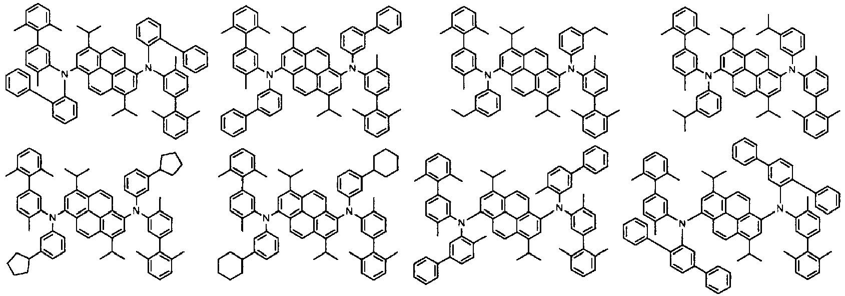

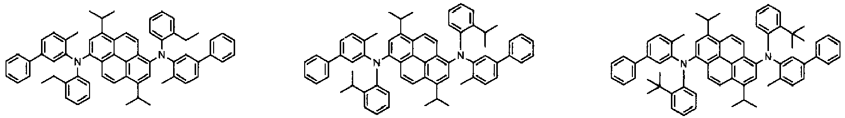

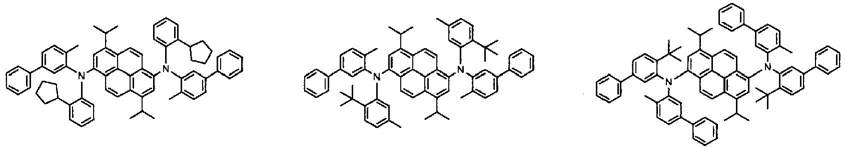

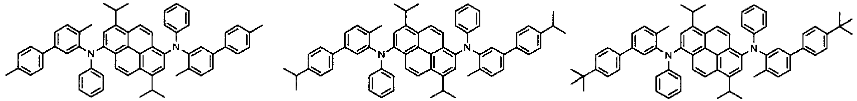

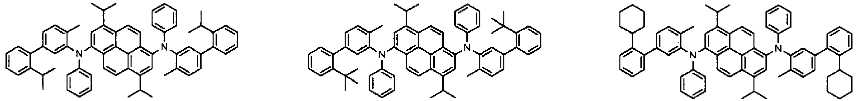

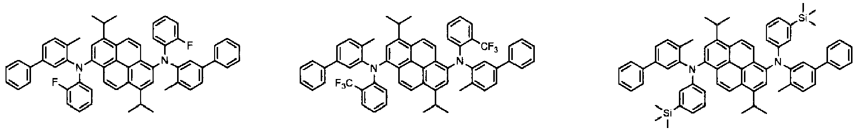

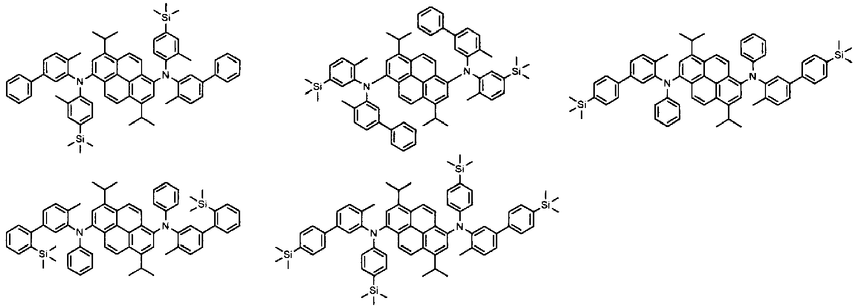

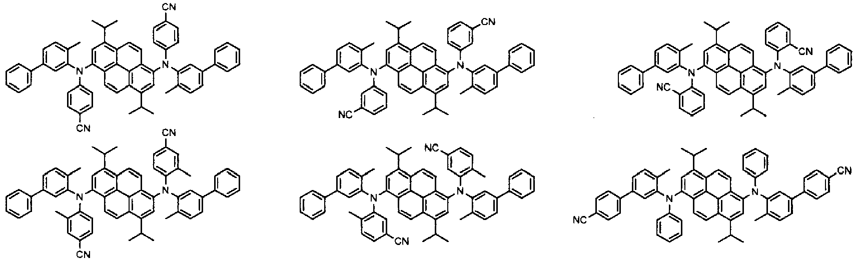

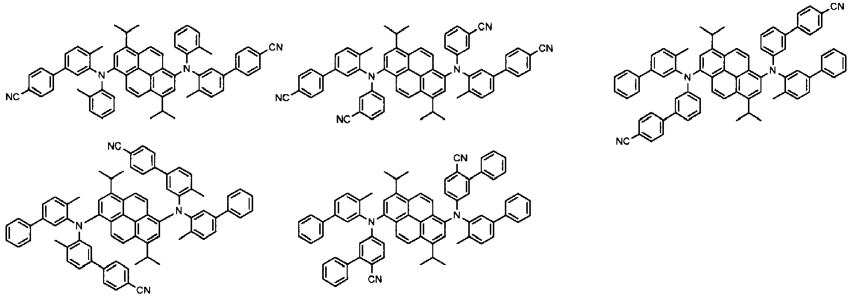

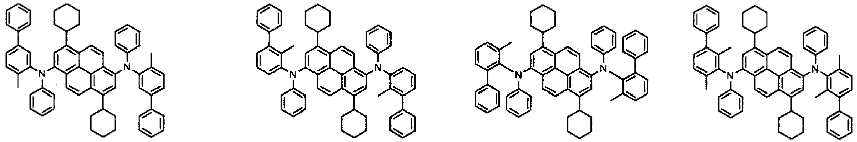

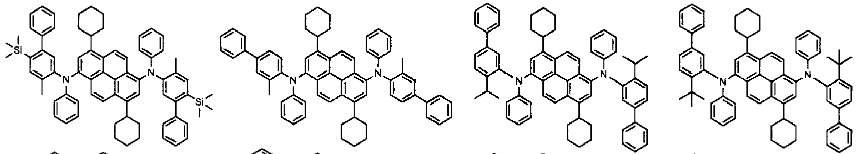

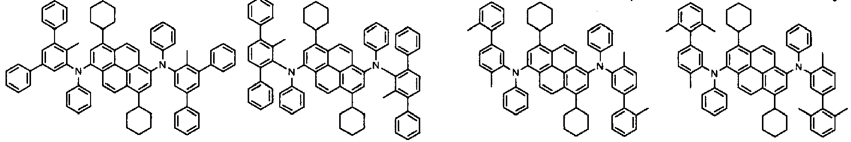

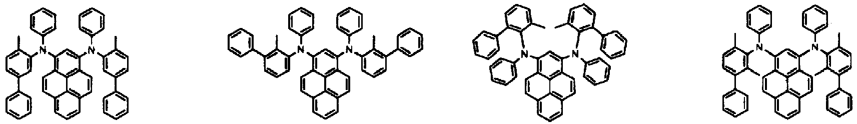

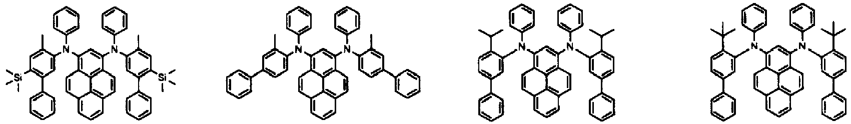

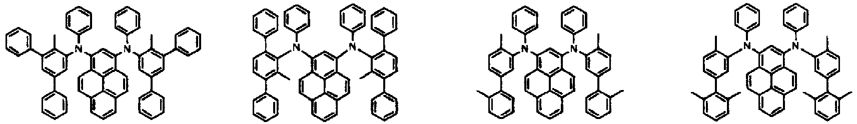

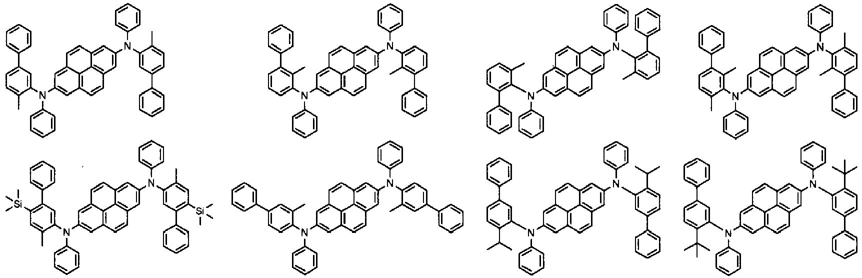

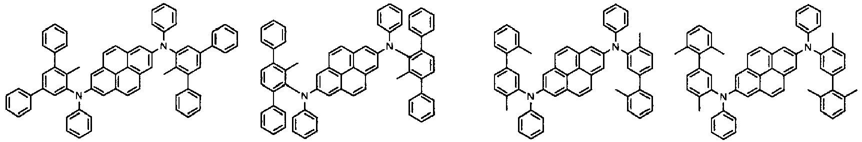

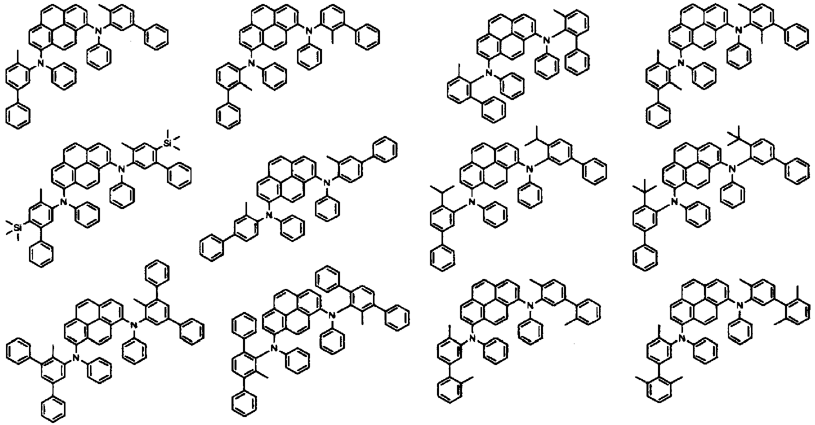

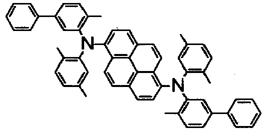

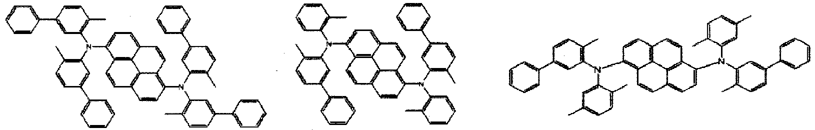

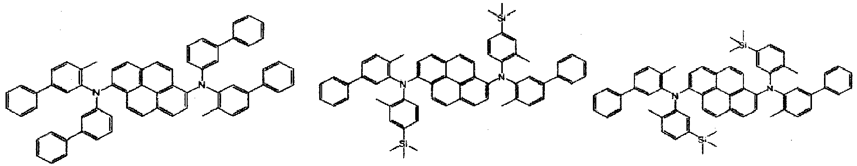

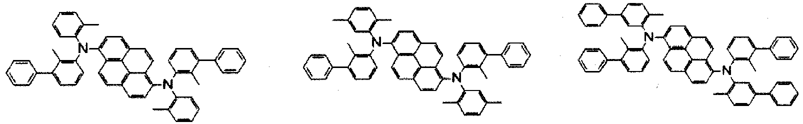

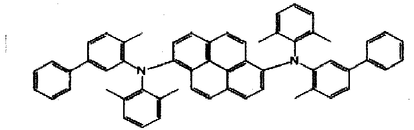

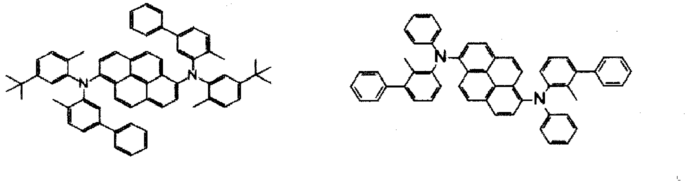

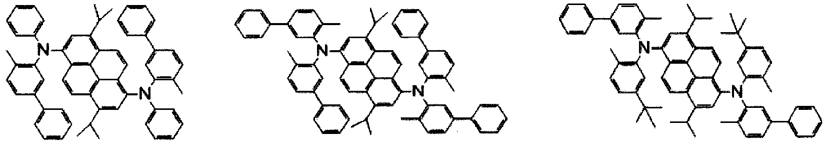

The compound represented by the formula (1) is preferably any compound selected from the group consisting of the following compounds:

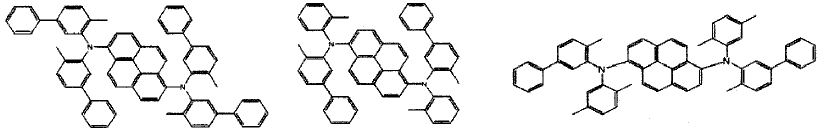

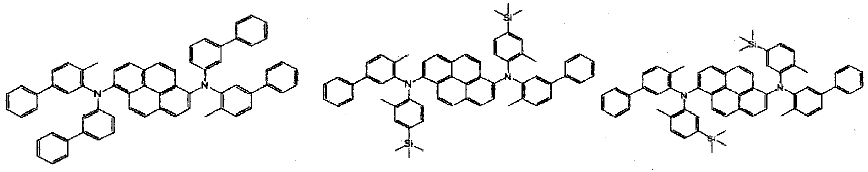

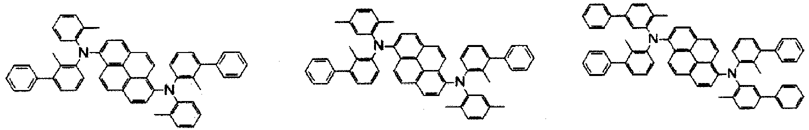

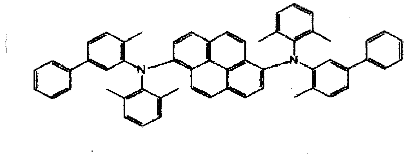

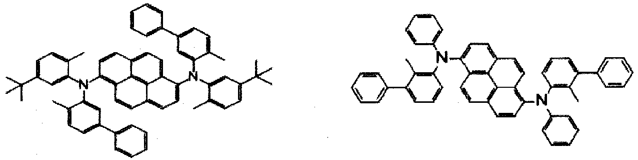

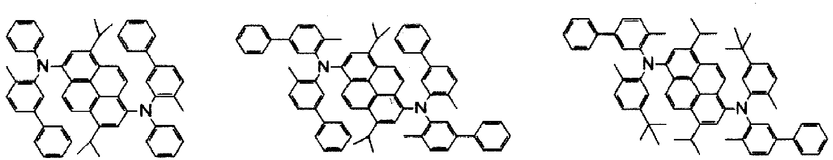

The emitting layer may consist only of the compound represented by the formula (1), or may comprise other compounds.

When the emitting layer comprises the compound represented by the formula (1) and other compounds, the content of the compound (1) is not particularly limited, but may be, for example, 0.1 to 70 mass%, preferably 1 to 20 mass%, more preferably 1 to 10 mass%, and particularly preferably 1 to 4 mass%, based on the emitting layer as a whole. The emitting layer preferably comprises the compound represented by the formula (1) and the anthracene derivative represented by the following formula (5). Preferably, the compound represented by the formula (1) is comprised as a dopant, and the anthracene derivative represented by the formula (5) is comprised as a host. 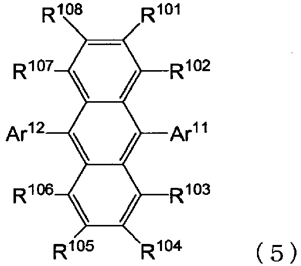 In formula (5), Ar¹¹ and Ar¹² are independently a substituted or unsubstituted monocyclic group including 5 to 50 ring atoms, a substituted or unsubstituted fused ring group including 8 to 50 ring atoms, or a group constituted by a combination of the monocyclic group and the fused ring group.

R¹⁰¹ to R¹⁰⁸ are independently selected from the group consisting of a hydrogen atom, a substituted or unsubstituted monocyclic group including 5 to 50 (preferably 5 to 30, more preferably 5 to 20, and still more preferably 5 to 12) ring atoms, a substituted or unsubstituted fused ring group including 8 to 50 (preferably 8 to 30, more preferably 8 to 20, and still more preferably 8 to 14) ring atoms, a group constituted by a combination of the monocyclic group and the fused ring group, a substituted or unsubstituted alkyl group including 1 to 50 (preferably 1 to 20, more preferably 1 to 10, and still more preferably 1 to 6) carbon atoms, a substituted or unsubstituted cycloalkyl group including 3 to 50 (preferably 3 to 20, more preferably 3 to 10, and still more preferably 5 to 8) ring carbon atoms, a substituted or unsubstituted alkoxy group including 1 to 50 (preferably 1 to 20, more preferably 1 to 10, and still more preferably 1 to 6) carbon atoms, a substituted or unsubstituted aralkyl group including 7 to 50 (preferably 7 to 20, and more preferably 7 to 14) carbon atoms, a substituted or unsubstituted aryloxy group including 6 to 50 (preferably 6 to 20, and more preferably 6 to 12) ring carbon atoms, a substituted or unsubstituted silyl group, a halogen atom, and a cyano group.

It is preferred that all of R¹⁰¹ to R¹⁰⁸ be hydrogen atoms, or that one of R¹⁰¹ and R¹⁰⁸, one of R¹⁰⁴ and R¹⁰⁶, both of R¹⁰¹ and R¹⁰⁶, or both of R¹⁰⁸ and R¹⁰⁴ be a group selected from the group consisting of a monocyclic group including 5 to 50 ring atoms (preferably a phenyl group, a biphenylyl group, a terphenylyl group), a substituted or unsubstituted alkyl group including 1 to 50 carbon atoms (preferably a methyl group, an ethyl group, an n-propyl group, an isopropyl group, an n-butyl group, an isobutyl group, a s-butyl group, a t-butyl group), and a substituted silyl group (preferably a trimethylsilyl group). It is more preferred that all of R¹⁰¹ to R¹⁰⁸ be hydrogen atoms.

The monocyclic group in the formula (5) is a group constituted only by a ring structure having no fused ring structure.

Examples of the monocyclic group including 5 to 50 ring atoms are preferably an aromatic group such as a phenyl group, a biphenylyl group, a terphenylyl group, and a quarterphenylyl groups, and a heterocyclic group such as a pyridyl group, a pyrazil group, a pyrimidyl group, a triazinyl group, a furyl group, and a thienyl group.

As the above monocyclic group, in particular, a phenyl group, a biphenylyl group, and a terphenylyl group are preferable.

In the formula (5), the fused ring group is a group in which two or more ring structures are condensed.

Examples of the fused ring group including 8 to 50 ring atoms are preferably a fused aromatic ring group such as a naphthyl group, a phenanthryl group, an anthryl group, a chrysenyl group, a benzanthryl group, a benzophenanthryl group, a triphenylenyl group, a benzochrysenyl group, an indenyl group, a fluorenyl group, a benzofluorenyl group, a dibenzofluorenyl group, a fluoranethenyl group, a benzofluoranethenyl group; and a fused heterocyclic group such as a benzofuranyl group, a benzothiophenyl group, an indolyl group, a dibenzofuranyl group, a dibenzothiophenyl group, a carbazolyl group, a quinolyl group, a phenanthrolinyl group.

The fluorenyl group may have one or two substituents at the 9-position, and examples of the substituent include an alkyl group, an aryl group, an alkylsilyl group, an arylsilyl group, an alkoxy group, and the like. Specific examples of such a fluorenyl group include, for example, a 9,9-dimethylfluorenyl group and a 9,9-diphenylfluorenyl group. When the fluorenyl group is described hereafter, it is permissible to have the same substituent unless otherwise noted.

As the above fused ring groups, in particular, a naphthyl group, a phenanthryl group, an anthryl group, a fluorenyl group (specifically, a 9,9-dimethylfluorenyl group and the like), a fluoranethenyl group, a benzanthryl group, a dibenzothiophenyl group, a dibenzofuranyl group, and a carbazolyl group are preferable.

Specific examples of the alkyl group, the cycloalkyl group (the cyclic alkyl group), the alkoxy group, the alkyl and aryl moieties of the aralkyl group, the aryloxy group, the substituted silyl group (the alkylsilyl group, the arylsilyl group), and the halogen atom in the formula (5) are the same as the specific examples of the groups in the formula (1) and the substituent in "substituted or unsubstituted...."

The aralkyl group is represented as -Y-Z, and examples of Y include alkylenes corresponding to the examples of alkyls described above, and examples of Z include the examples of aryls described above. The aralkyl group is preferably a aralkyl group including 7 to 50 carbon atoms (an aryl moiety including 6 to 49 (preferably 6 to 30, more preferably 6 to 20, particularly preferably 6 to 12) carbon atoms and an alkyl moiety including 1 to 44 (preferably 1 to 30, more preferably 1 to 20, still more preferably 1 to 10, particularly preferably 1 to 6) carbon atoms, for example a benzyl group, a phenylethyl group, a 2-phenylpropane-2-yl group.

As a preferable substituent of "substituted or unsubstituted" of Ar¹¹, Ar¹² and R¹ to R⁸, a monocyclic group, a fused ring group, an alkyl group, a cycloalkyl group, a silyl group, an alkoxy group, a cyano group, or a halogen atom (particularly fluorine) is preferable, and a monocyclic group and a fused ring group are particularly preferable, and a preferable specific substituent is as described above.

As the substituent in Ar¹¹ and Ar¹², the above monocyclic group or fused ring group is preferable.

The anthracene derivative represented by the formula (5) is preferably any of the following anthracene derivatives (A), (B) and (C), and is selected based on the configuration and the described properties of the objective organic EL devices.

### (Anthracene derivative (A))

In the anthracene derivative (A), Ar¹¹ and Ar¹² in the formula (5) are independently a substituted or unsubstituted fused ring groups including 8 to 50 ring atoms. As the anthracene derivative, Ar¹¹ and Ar¹² may be the same or different.

The anthracene derivative in which Ar¹¹ and Ar¹² in the formula (5) are different (including differences in the position with which the anthracene ring is bonded) substituted or unsubstituted fused ring groups are particularly preferred, and preferred specific examples of the fused ring are described above. In particular, a naphthyl group, a phenanthryl group, a benzantryl group, a fluorenyl groups (specifically a 9,9-dimethylfluorenyl group and the like) and a dibenzofuranyl group are preferred.

### (Anthracene derivative (B))

In the anthracene derivative (B), one of Ar¹¹ and Ar¹² in the formula (5) is a substituted or unsubstituted monocyclic group including 5 to 50 ring atoms, and the other of Ar¹¹ and Ar¹² is a substituted or unsubstituted fused ring group including 8 to 50 ring atoms.

Preferred embodiments of the anthracene derivative (B) include derivatives in which Ar¹² is a naphthyl group, a phenanthryl group, a benzanthryl group, a fluorenyl group (specifically, a 9,9-dimethylfluorenyl group and the like) or a dibenzofuranyl group and Ar¹¹ is an unsubstituted phenyl group or a phenyl group substituted by a monocyclic group or a fused ring group (for example, a phenyl group, a biphenyl group, a naphthyl group, a phenanthryl group, a fluorenyl group (specifically, a 9,9-dimethylfluorenyl group and the like), or a dibenzofuranyl group). Specific groups of preferable monocyclic groups and fused ring groups are as described above.

Another preferred embodiments of the anthracene derivative (B) include a derivatives in which Ar¹² is a substituted or unsubstituted fused ring group including 8 to 50 ring atoms and Ar¹¹ is an unsubstituted phenyl group. As the fused ring group, a phenanthryl group, a fluorenyl group (specifically, a 9,9-dimethylfluorenyl group and the like), a dibenzofuranyl group, and a benzanthryl group are particularly preferable.

### (Anthracene derivative (C))

In the anthracene derivative (C), Ar¹¹ and Ar¹² in the formula (5) are independently a substituted or unsubstituted monocyclic group including 5 to 50 ring atoms.

Preferable embodiments of the anthracene derivative (C) include derivatives in which both Ar¹¹ and Ar¹² are substituted or unsubstituted phenyl groups. More preferable embodiments include the case where Ar¹¹ is an unsubstituted phenyl group and Ar¹² is a phenyl group substituted by a monocyclic group or a fused ring group, and the case where Ar¹¹ and Ar¹² are independently a phenyl group substituted by a monocyclic group or a fused ring group.

Preferable specific examples of the monocyclic group and the fused ring group as the substituent are as described above. More preferable monocyclic groups as a substituent is a phenyl group or a biphenyl group, and more preferable fused ring groups as a substituent is a naphthyl group, a phenanthryl group, a fluorenyl group (specifically, a 9,9-dimethylfluorenyl group and the like), a dibenzofuranyl group, or a benzanthryl group.

Specific examples of the anthracene derivative represented by the formula (5) include the following compounds:

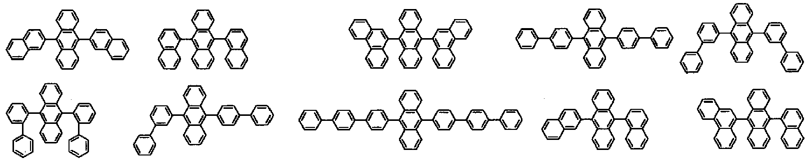

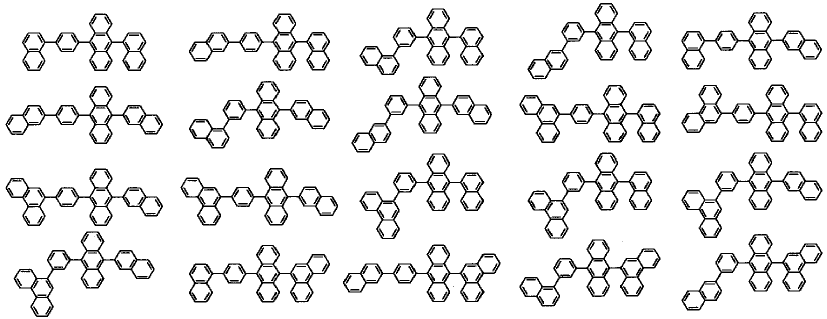

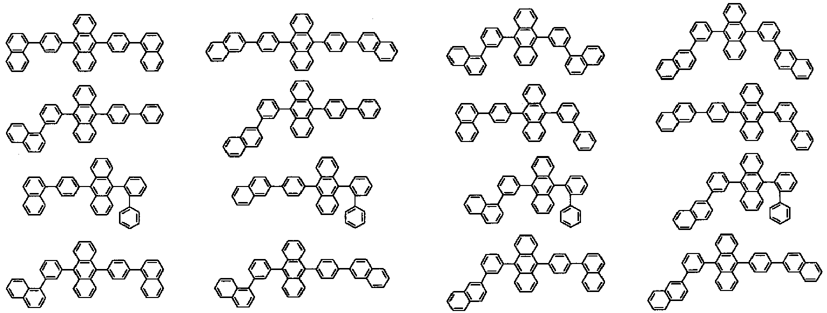

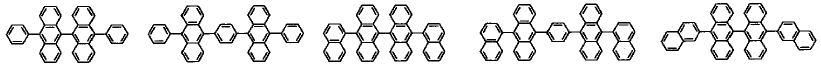

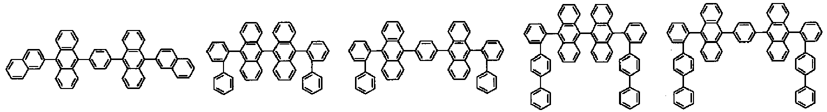

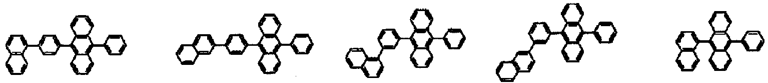

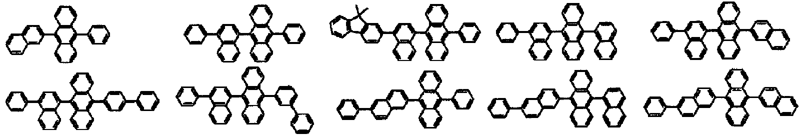

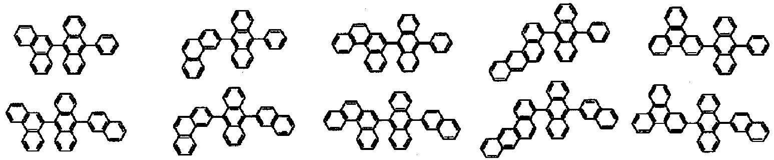

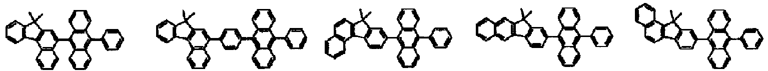

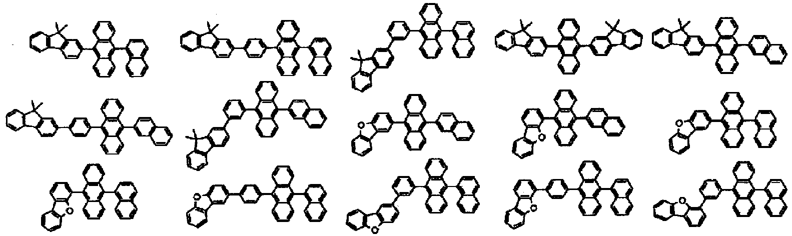

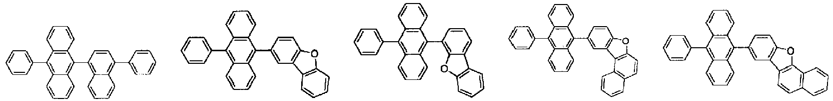

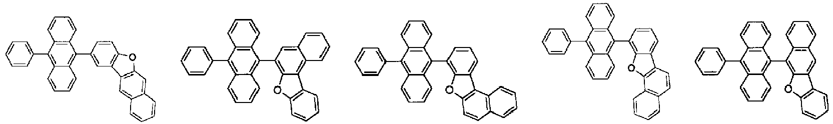

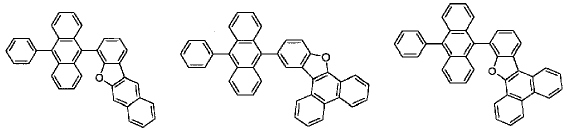

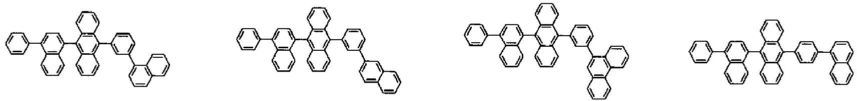

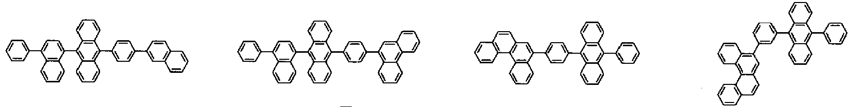

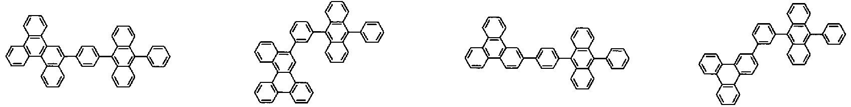

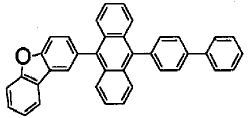

### (Organic layer comprising compound represented by the formula (20))

As described above, in the organic EL device according to an aspect of the invention, an organic layer (usually, one or more organic layers constituting a hole-transporting zone) between an anode and an emitting layer comprises a compound represented by the following formula (20). 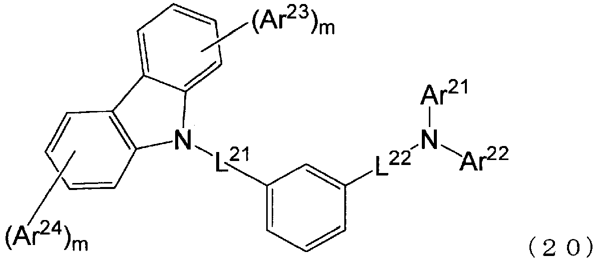
In the formula (20), Ar²¹ to Ar²⁴ are independently a substituted or unsubstituted aryl group including 6 to 50 ring carbon atoms or a substituted or unsubstituted heteroaryl group including 5 to 50 ring atoms,
m is an integer of 0 to 4,
L²¹ and L²² are independently a single bond, a substituted or unsubstituted arylene group including 6 to 18 ring carbon atoms, or a substituted or unsubstituted heteroarylene group including 5 to 15 ring carbon atoms,
when m is an integer of 2 or more, plural Ar²³ may be the same or different, and plural Ar²⁴ may be the same or different.

In the formula (20), adjacent Ar²¹ to Ar²⁴ may form a ring. That is, Ar²¹ and Ar²² adjacent to each other may be bonded with each other to form a ring. Adjacent Ar²³ may be bonded with each other to form a ring and adjacent Ar²⁴ may be bonded with each other to form a ring.

Specific examples of Ar²¹ to Ar²⁴ include a phenyl group, a biphenyl group, a terphenyl group, a naphthyl group, an anthryl group, a phenanthryl group, a fluorenyl group, an indenyl group, a pyrenyl group, an acetonaphthenyl group, a fluoranethenyl group, a triphenylenyl group, a pyridyl group, a pyranyl group, a quinolyl group, an isoquinolyl group, a benzofuranyl group, a benzothienyl group, an indolyl group, a carbazolyl group, a benzooxazolyl group, a benzothiazolyl group, a quinoxalyl group, a benzimidazolyl group, a dibenzofuranyl group, and a dibenzothienyl group. Preferably, a phenyl group, a biphenyl group, a terphenyl group, a fluorenyl group, a carbazolyl group, a dibenzofuranyl group and the like may be listed.

In addition to a single bond, examples of L²¹ and L²² include a phenylene group, a biphenylylene group, a terphenylylene group, a naphthylene group, an anthrylene group, a phenanthrylene group, a fluorylene group, an indandiyl group, a pyrenediyl group, an acenaphthenediyl group, a fluoranthenediyl group, a triphenylenediyl group, a pyridinediyl group, a pyrandiyl group, a quinolinediyl group, an isoquinolinediyl group, a benzofurandiyl group, a benzothiophenediyl group, an indolediyl group, a carbazolediyl group, a benzoxazolediyl group, a benzothiazolediyl group, a quinoxalinediyl group, a benzoimidazolediyl group, a dibenzofurandiyl group, and the like. Preferable examples include a phenylene group, a terphenylene group, a fluorenediyl group, a carbazolediyl group, a dibenzofurandiyl group, and the like.

Examples of the substituent in "substituted or unsubstituted..." include each of the groups listed for the formula (1). These substituents may further be substituted by the same substituent. A plurality of these substituents may be bonded with each other to form a ring.

The compound represented by the formula (20) can be synthesized by known methods. Examples of the compound represented by the formula (20) include the following compounds. However, the compound represented by the formula (20) is not limited to the following compounds.

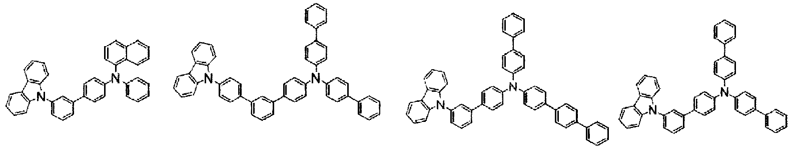

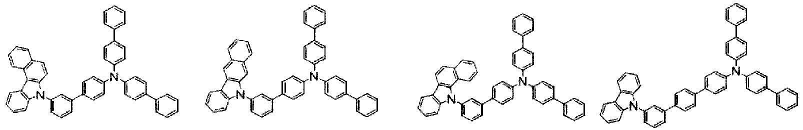

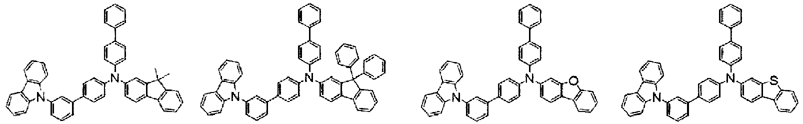

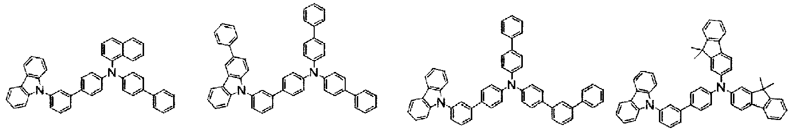

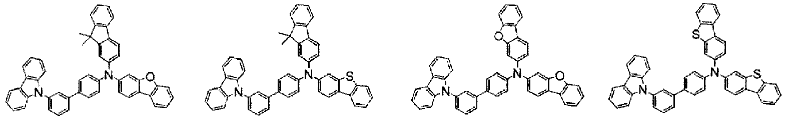

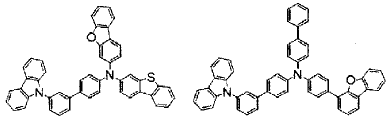

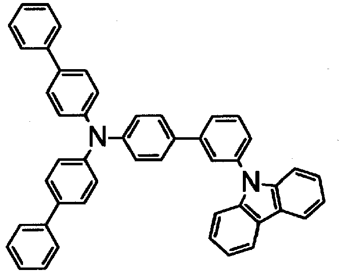

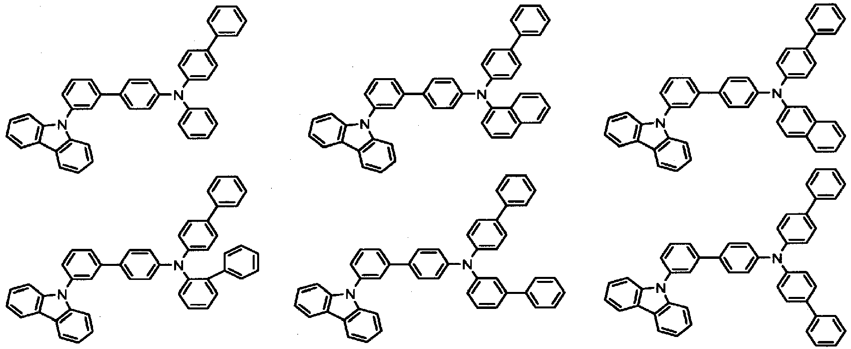

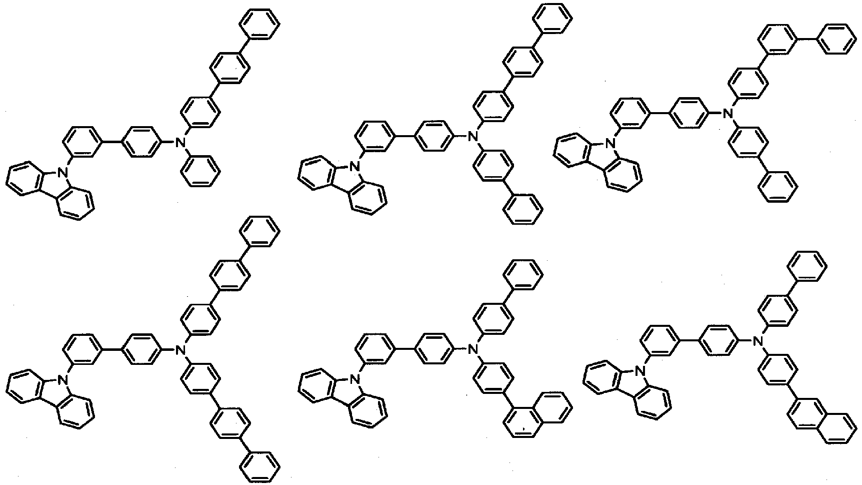

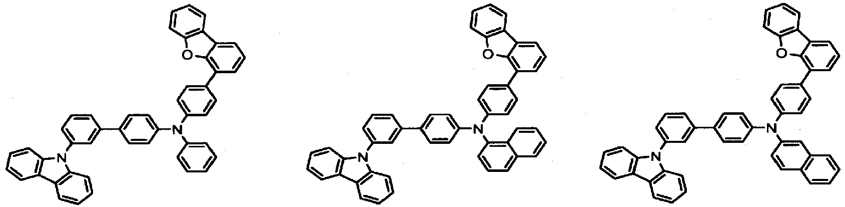

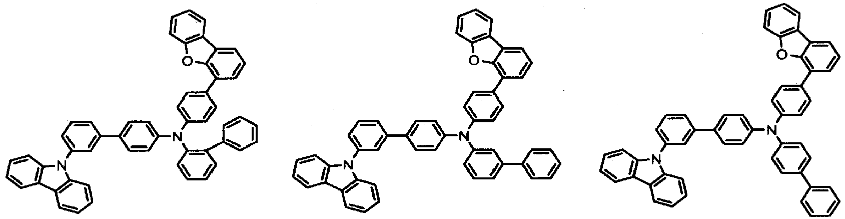

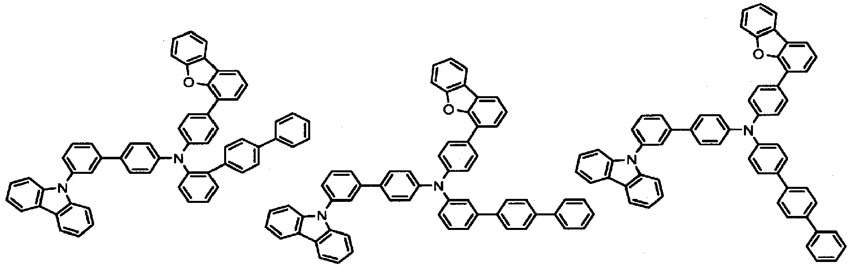

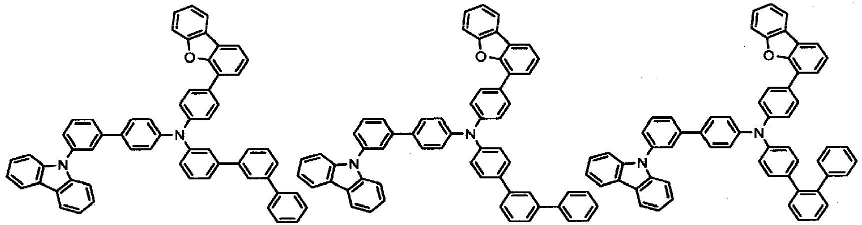

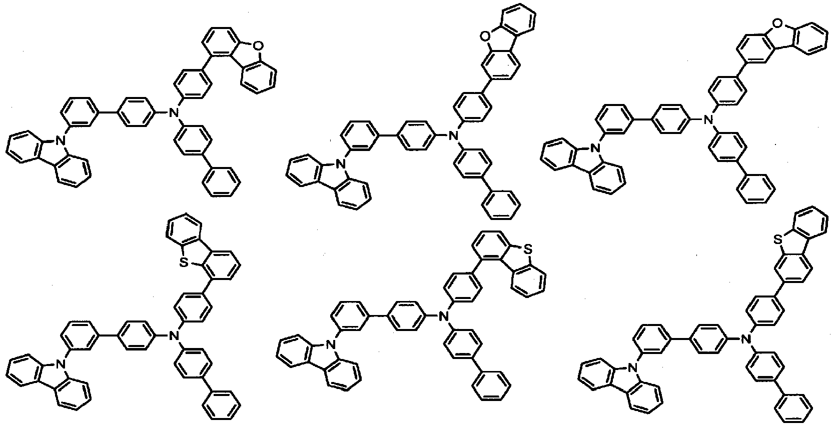

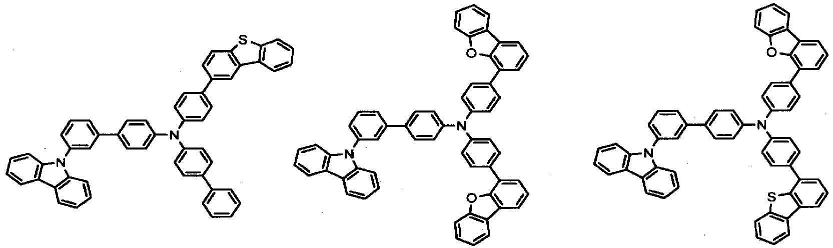

The compound represented by the formula (20) is preferably any of the compound selected from the group consisting of the following compounds:

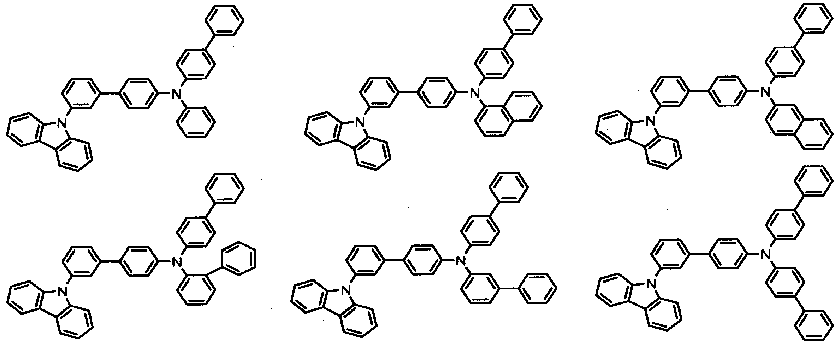

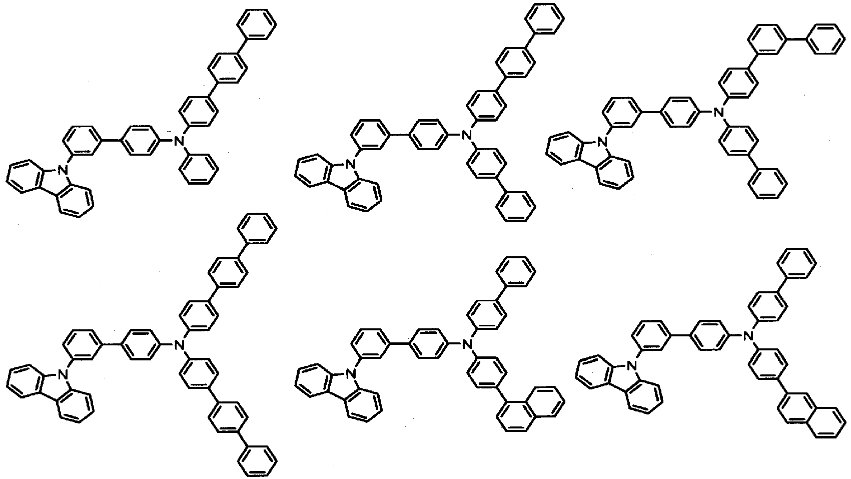

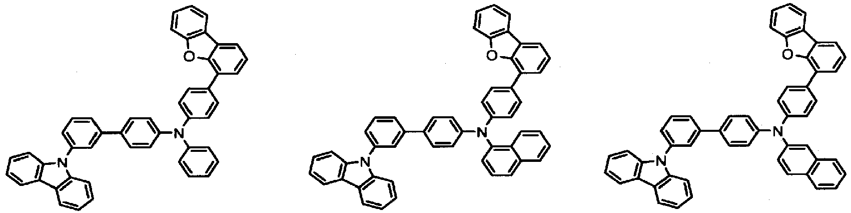

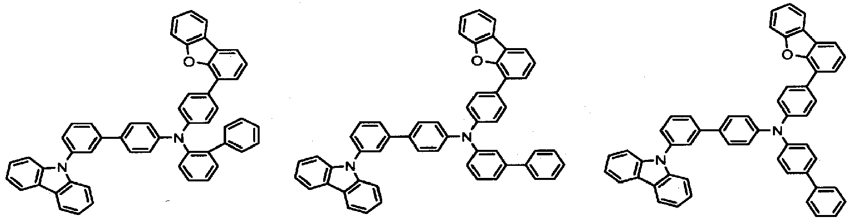

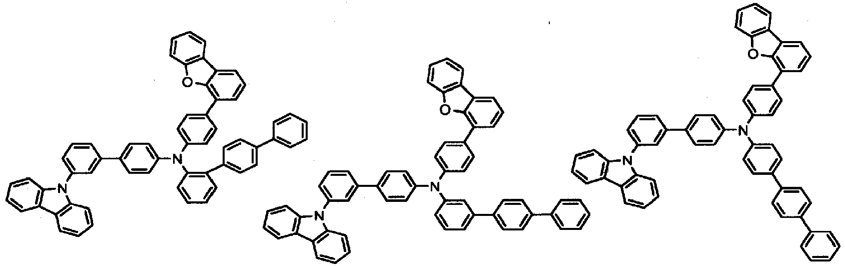

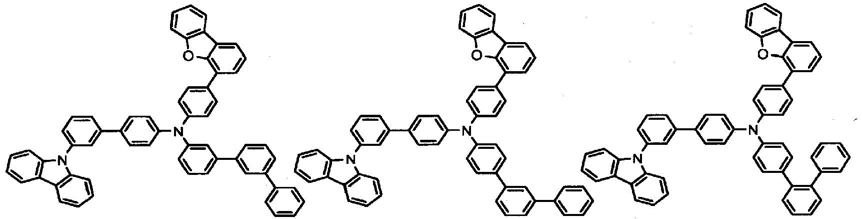

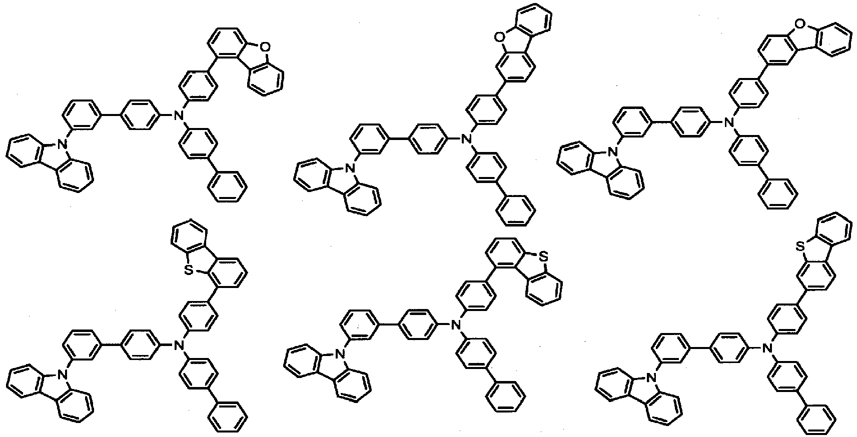

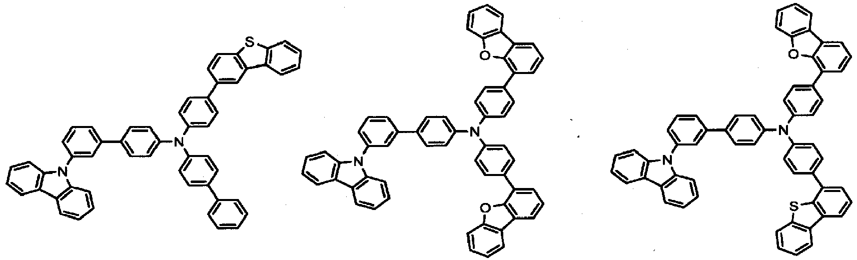

### (Anode)

For the anode, metals, alloys, electrically conductive compounds, mixtures thereof, and the like having large work functions (specifically, 4.0 eV or more) are preferably used. Specific examples thereof include indium oxide-tin oxide (ITO: Indium Tin Oxide), indium oxide-tin oxide comprising silicon or silicon oxide, indium oxide-zinc oxide, tungsten oxide, indium oxide comprising zinc oxide, and graphene. In addition thereto, specific examples thereof include gold (Au), platinum (Pt), or a nitride of a metallic material (for example, titanium nitride) and the like.

### (Hole-injecting layer)

The hole-injecting layer is a layer comprising a material having high hole-injecting property (a hole-injecting material).

As the hole-injecting material, molybdenum oxide, titanium oxide, vanadium oxide, rhenium oxide, ruthenium oxide, chromium oxide, zirconium oxide, hafnium oxide, tantalum oxide, silver oxide, tungsten oxide, manganese oxide, and the like can be used.

Aromatic amine compounds, which are low-molecular organic compounds such as 4,4',4"-tris(N,N-diphenylamino)triphenylamine (abbreviation: TDATA), 4,4',4"-tris[N-(3-methylphenyl)-N-phenylamino]triphenylamine (abbreviation: MTDATA), 4,4'-bis[N-(4-diphenylaminophenyl)-N-phenylamino]biphenyl (abbreviation: DPAB), 4,4'-bis(N-{4-[N'-(3-methylphenyl)-N'-phenylamino]phenyl}-N-phenylamino)biphenyl (abbreviation: DNTPD), 1,3,5-tris[N-(4-diphenylaminophenyl)-N-phenylamino]benzene (abbreviation: DPA3B), 3-[N-(9-phenylcarbazol-3-yl)-N-phenylamino]-9-phenylcarbazole (abbreviation: PCzPCA1), 3,6-bis[N-(9-phenylcarbazol-3-yl)-N-phenylamino]-9-phenylcarbazole (abbreviation: PCzPCA2), 3-[N-(1-naphthyl)-N-(9-phenylcarbazol-3-yl)amino]-9-phenylcarbazole (abbreviation: PCzPCN1) can also be used as the hole-injecting layer material.

Polymeric compounds (oligomers, dendrimers, polymers, and the like) can also be used. Examples thereof include polymeric compounds such as poly(N-vinylcarbazole) (abbreviation: PVK), poly(4-vinyltriphenylamine) (abbreviation: PVTPA), poly[N-(4-{N'-[4-(4-diphenylamino)phenyl]phenyl-N'-phenylamino}phenyl)methacrylamide (abbreviation: PTPDMA), and poly[N,N'-bis(4-butylphenyl)-N,N'-bis(phenyl)benzidine (abbreviation: Poly-TPD). In addition, a polymer compound to which an acid is added, such as poly(3,4-ethylenedioxythiophene)/poly(styrenesulfonate) (PEDOT/PSS), polyaniline/poly(styrenesulfonate) (PAni/PSS) and the like, can also be used as the hole-injecting material.

In addition, an acceptor material such as a hexaazatriphenylene (HAT) compound represented by the following formula (K) can be used as the hole-injecting material.

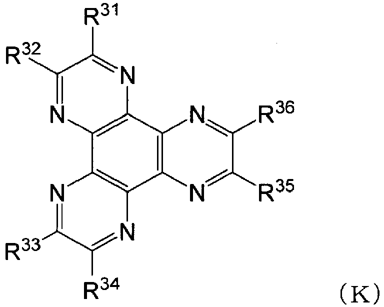

In the formula (K), R³¹ to R³⁶ independently represent a cyano group, -CONH₂, a carboxylic group, or -COOR³⁷ (R³⁷ represents an alkyl group including 1 to 20 carbon atoms or a cycloalkyl group including 3 to 20 carbon atoms). Two adjacent groups of R³¹ and R³², R³³ and R³⁴, and R³⁵ and R³⁶, may be bonded with each other to form a group represented by -CO-O-CO-.

Examples of R³⁷ include a methyl group, an ethyl group, a n-propyl group, an isopropyl group, a n-butyl group, an isobutyl group, a t-butyl group, a cyclopentyl group, and a cyclohexyl group.

As the hole-injecting material, a compound represented by the following formula (2-1) and a compound represented by the following formula (2-2) are preferable.

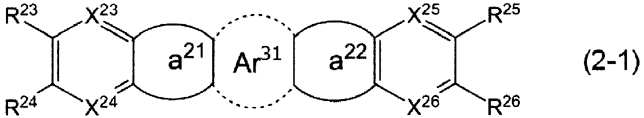

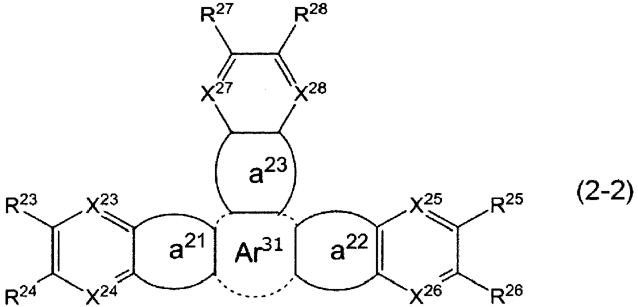

In the formulas (2-1) and (2-2), Ar³¹ represents a substituted or unsubstituted aromatic hydrocarbon ring including 6 to 30 ring carbon atoms or a substituted or unsubstituted aromatic heterocyclic ring including 5 to 30 ring atoms. The aromatic hydrocarbon ring is preferably a benzene ring. The aromatic heterocyclic ring is preferably a ring including 6 ring atoms, for example, a pyridine ring, a pyrazine ring, or a pyridazine ring.

In the formulas (2-1) and (2-2), X²³ to X²⁸ are independently C(R) or a nitrogen atom.

R is a hydrogen atom, a halogen atom, a hydroxyl group, a cyano group, a substituted or unsubstituted alkyl group including 1 to 30 carbon atoms, a substituted or unsubstituted aryl group including 6 to 30 ring carbon atoms; a monosubstituted, disubstituted or trisubstituted silyl group having one or more substituents selected from the group consisting of a substituted or unsubstituted alkyl group including 1 to 30 carbon atoms and a substituted or unsubstituted aryl group including 6 to 30 ring carbon atoms; an alkoxy group having a substituted or unsubstituted alkyl group including 1 to 30 carbon atoms, an aryloxy group having a substituted or unsubstituted aryl group including 6 to 30 ring carbon atoms ; a monosubstituted or disubstituted amino group having one or more substituents selected from the group consisting of a substituted or unsubstituted alkyl group including 1 to 30 carbon atoms, and a substituted or unsubstituted aryl group including 6 to 30 ring carbon atoms; an alkylthio group having a substituted or unsubstituted alkyl group including 1 to 30 carbon atoms, an arylthio group having a substituted or unsubstituted aryl group including 6 to 30 ring carbon atoms, or a substituted or unsubstituted heteroaryl group including 5 to 30 ring atoms.

Examples of the alkyl group, the aryl group, the alkoxy group, the aryloxy group, the alkylthio group, the arylthio group, and the heteroaryl group include the groups listed for the formula (1).

Examples of the silyl group include a silyl group substituted by one or more groups selected from the group consisting of the alkyl group and the aryl group described above.

Examples of the amino group include an amino group substituted by one or more groups selected from the group consisting of the alkyl group and the aryl group described above.

Examples of the substituent in "substituted or unsubstituted..." include the groups listed for the formula (1). These substituents may further be substituted by the same substituent. A plurality of these substituents may be bonded with each other to form a ring.

In the formulas (2-1) and (2-2), a²¹ to a²³ are a ring represented by the following formula (2b).

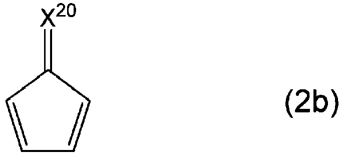

X²⁰ of the formula (2b) is represented by any of the following formulas (2b-1) to (2b-12).

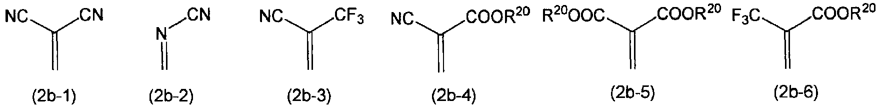

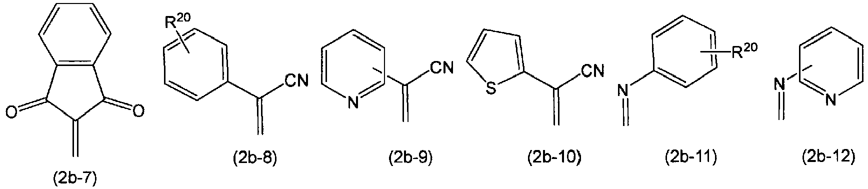

In the formulas (2b-1) to (2b-12), R²⁰ is the same as R.

In the formulas (2-1) and (2-2), R²³ to R²⁸ are independently the same as R.

Specific examples of the compound represented by the formula (2-1) and the compound represented by the formula (2-2) are described below, but are not limited to the following compounds.

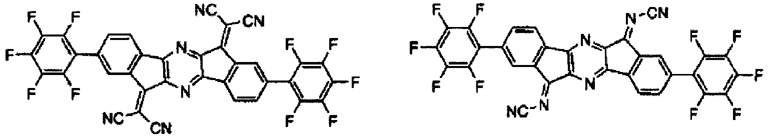

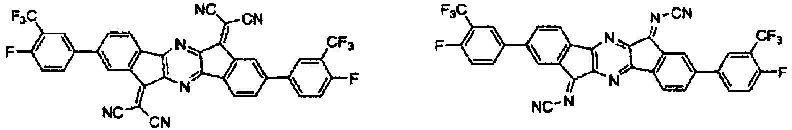

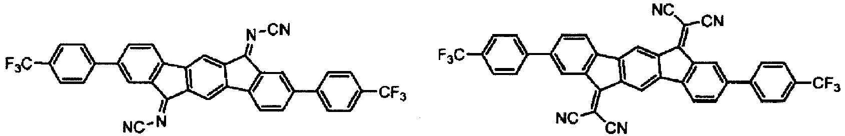

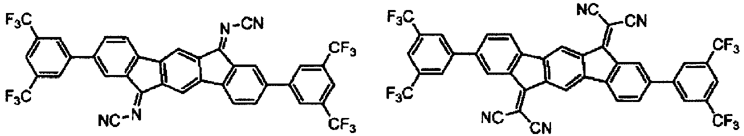

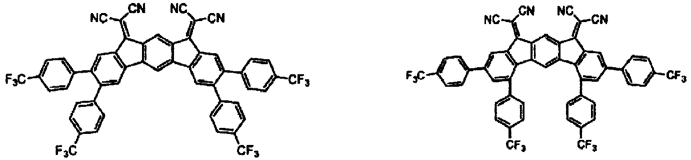

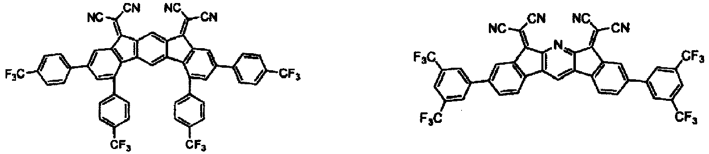

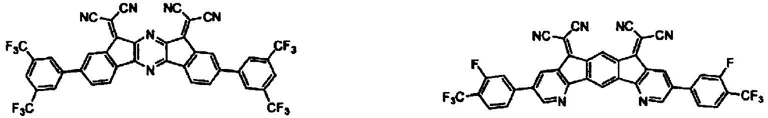

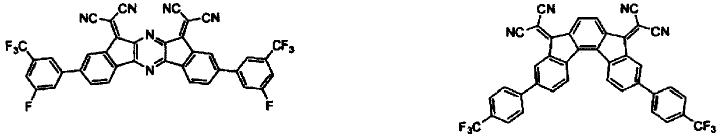

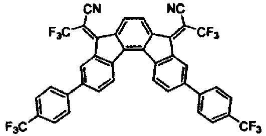

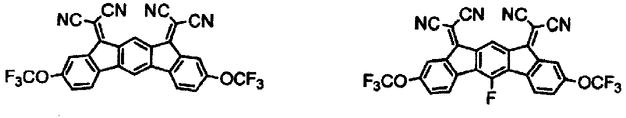

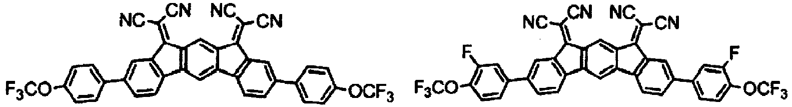

The hole-injecting layer may further comprise a compound comprising 2 to 6 aromatic six-membered rings and a linking moiety including the structure represented by the formula (2a) that links the aromatic six-membered rings.

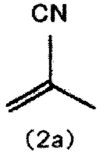

Specific examples of the above compound include a compound represented by the following formula (2). 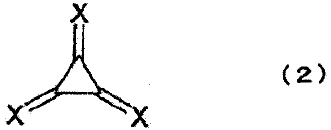 In the formula (2), X are independently a group represented by the following formula.

R²⁰⁰-C*-CN

In the above formula, C* is a carbon atom bonded with cyclopropane of the formula (2) by a double bond. R²⁰⁰ are independently an aromatic six-membered ring substituted by one or more selected from an aromatic six-membered ring, a halogen atom, a substituted or unsubstituted fluoroalkyl group, a substituted or unsubstituted fluoroalkoxy group, and a cyano group.

Examples of the halogen atom include those listed in the formula (1).

Examples of the aromatic six-membered ring include a six-membered ring among the aryl groups and the heteroaryl groups listed for the formula (1).

Examples of the fluoroalkyl group include a group obtained by combining the alkyl group listed fot the formula (1) and a fluorine atom.

Examples of the fluoroalkoxy group include a group obtained by combining the alkoxy group listed for the formula (1) and a fluorine atom.

Examples of the substituent in "substituted or unsubstituted..." include the groups listed for the formula (1). These substituents may further be substituted by the same substituent. A plurality of these substituents may be bonded with each other to form a ring.

R²⁰⁰ of the formula (2) is preferably perfluoropyridine-4-yl, tetrafluoro-4-(trifluoromethyl)phenyl group, 4-cyanoperfluorophenyl, dichloro-3,5-difluoro-4-(trifluoromethyl)phenyl, or perfluorophenyl.

Specific compounds of the formula (2) include (2E,2'E,2"E)-2,2',2"-(cyclopropane-1,2,3-triylidene)tris(2-(perfluorophenyl)-acetonitrile), (2E,2'E,2"E)-2,2',2"-(cyclopropane-1,2,3-triylidene)tris(2-(perfluoropyridin-4-yl)-acetonitrile), (2E,2'E,2"E)-2,2',2"-(cyclopropane-1,2,3-triylidene)tris(2-(4-cyanoperfluorophenyl)- -acetonitrile), (2E,2'E,2"E)-2,2',2"-(cyclopropane-1,2,3-triylidene)tris(2-(2,3,5,6-tetrafluoro-4-(trifluoromethyl)phenyl)-acetonitrile), or (2E,2'E,2"E)-2,2',2"-(cyclopropane-1,2,3-triylidene)tris(2-(2,6-dichloro-3,5-difluoro-4-(trifluoromethyl)phenyl)-acetonitrile).

The compound of the formula (2) will be exemplified below.

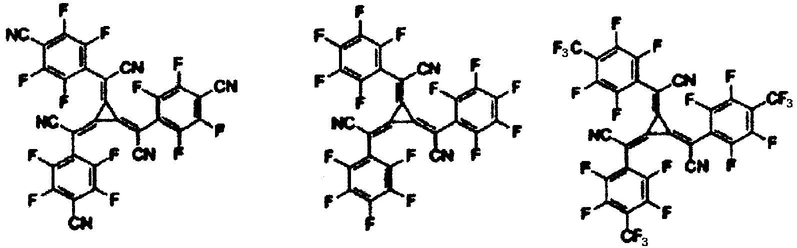

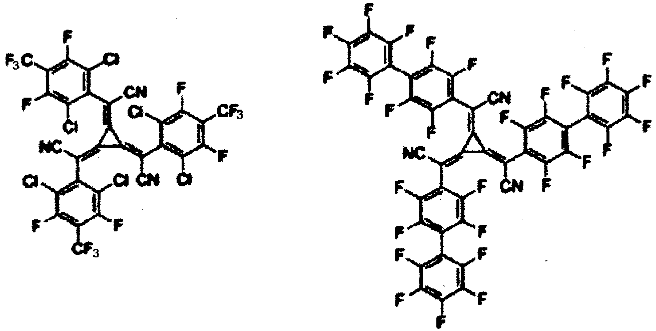

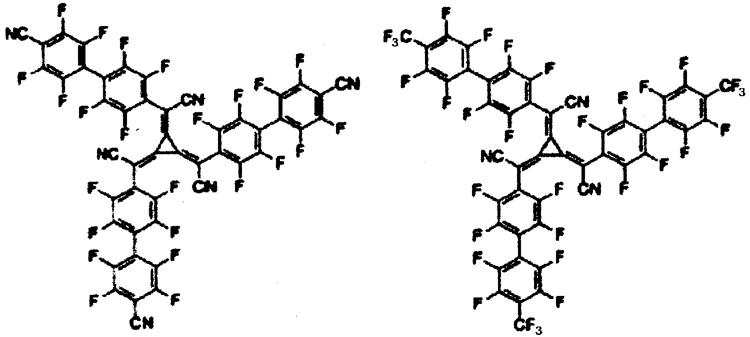

When the hole-injecting layer comprises the compound represented by the formula (20), a single hole-injecting layer may comprise the compound represented by the formula (20), a single hole-injecting layer may comprise the above compound and the compound represented by the formula (20), or a hole-injecting layer comprising the above compound and a hole-injecting layer comprising the compound represented by the formula (20) may be provided separately.

### (Hole-transporting layer)

As the material for forming the hole-transporting layer, an aromatic amine compound, for example, an aromatic amine derivative represented by the following formula (H) is preferably used.

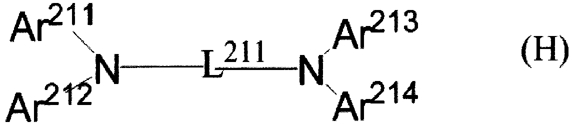

In the formula (H), Ar²¹¹ to Ar²¹⁴ independently represent an aryl group including 6 to 50 (preferably 6 to 30, more preferably 6 to 20, still more preferably 6 to 12) ring carbon atoms, a fused aryl group including 10 to 50 (preferably 10 to 30, more preferably 10 to 20) ring carbon atoms, a substituted or unsubstituted heteroaryl group including 5 to 50 (preferably 5 to 30, more preferably 5 to 20, still more preferably 5 to 12) ring atoms, a substituted or unsubstituted fused heteroaryl group including 8 to 50 (preferably 8 to 30, more preferably 8 to 20) ring atoms, or a group in which the aryl group or the fused aryl group is bonded with the heteroaryl group or the fused heteroaryl group. Ar²¹¹ and Ar²¹², and Ar²¹³ and Ar²¹⁴ may be bonded each other to form a saturated or unsaturated ring structure.

L²¹¹ represents a substituted or unsubstituted arylene group including 6 to 50 (preferably 6 to 30, more preferably 6 to 20, still more preferably 6 to 12) ring carbon atoms, a substituted or unsubstituted fused arylene group including 10 to 50 (preferably 10 to 30, more preferably 10 to 20) ring carbon atoms, a substituted or unsubstituted heteroarylene group including 5 to 50 (preferably 5 to 30, more preferably 5 to 20, still more preferably 5 to 12) ring atoms, or a substituted or unsubstituted fused heteroarylene group including 8 to 50 (preferably 8 to 30, more preferably 8 to 20) ring atoms.

Examples of the aryl group and the arylene group include the aryl group listed for the formula (1) and the corresponding divalent group.

Examples of the fused aryl group and the fused arylene group include the fused aryl group among the fused ring listed for the formula (5) and the corresponding divalent group.

Examples of the heteroaryl group and the heteroarylene group include the heteroaryl group listed for the formula (1) and the corresponding divalent group.

Examples of the fused heteroaryl group and the fused heteroarylene group include the fused heteroaryl group among the fused ring listed for the formula (5) and the corresponding divalent group.

Examples of the substituent in "substituted or unsubstituted..." include the groups listed for the formula (1). These substituents may further be substituted by the same substituent. A plurality of these substituents may be bonded with each other to form a ring.

The aromatic amine of the following formula (J) (a compound represented by formula (J)) is also preferably used to form the hole-transporting layer.

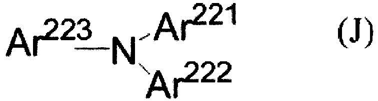

In the formula (J), Ar²²¹ to Ar²²³ independently represent a substituted or unsubstituted aryl group including 6 to 50 (preferably 6 to 30, more preferably 6 to 20, still more preferably 6 to 12) ring carbon atoms, a substituted or unsubstituted fused aryl group including 10 to 50 (preferably 10 to 30, more preferably 10 to 20) ring carbon atoms, a substituted or unsubstituted heteroaryl group including 5 to 50 (preferably 5 to 30, more preferably 5 to 20, still more preferably 5 to 12) ring atoms, a substituted or unsubstituted fused heteroaryl group including 8 to 50 (preferably 8 to 30, more preferably 8 to 20) ring atoms, or a group in which the aryl group or the fused aryl group is bonded with the heteroaryl group or the fused heteroaryl group. Ar²²¹ and Ar²²², Ar²²² and Ar²²³, and Ar²²¹ and Ar²²³ may be bonded with each other to form a saturated or unsaturated ring structure.

When the hole-transporting layer comprises the compound represented by the formula (20), a single hole-transporting layer may comprise the compound represented by the formula (20), a single hole-transporting layer may comprise the above compound and the compound represented by the formula (20), or a hole-transporting layer comprising the above compound and a hole-transporting layer containing the compound represented by the formula (20) may be provided separately.

When the organic EL device in an aspect of the invention contains two or more hole-transporting layers, the thickness of the hole-transporting layer in contact with the emitting layer is not particularly limited, but is, for example, 0.1 to 20 nm, preferably 20 nm or less, more preferably 10 nm or less, and still more preferably 5 nm or less.

The organic layer comprising the compound represented by the formula (20) is preferably a hole-transporting layer. Preferably, the organic layer comprising the compound represented by the formula (20) is directly adjacent to the emitting layer.

### (Electron-transporting layer)

The electron-transporting layer is a layer comprising a material having a high electron-transporting property (an electron-transporting material). Examples of the electron-transporting layer material include the compound represented by the following (1) to (3).
(1) A metal complex such as an aluminum complex, a beryllium complex, and a zinc complex
(2) An aromatic heterocyclic compound such as an imidazole derivative, a benzimidazole derivative, an azine (nitrogen-containing six-membered ring) derivative, a carbazole derivative, a phenanthroline derivative
(3) A polymer compound

Preferably, the electron-transporting layer comprises a carbazole derivative and the carbazole derivative is a compound comprising a carbazole ring and a nitrogen-containing six-membered ring.

Examples of the nitrogen-containing six-membered ring in the compound comprising a carbazole ring and a nitrogen-containing six-membered ring include a pyrimidine ring, a triazine ring, and a pyridine ring. A pyrimidine ring is particularly preferable.

It is preferable that the electron-transporting layer comprise the compound represented by the following formula (M).

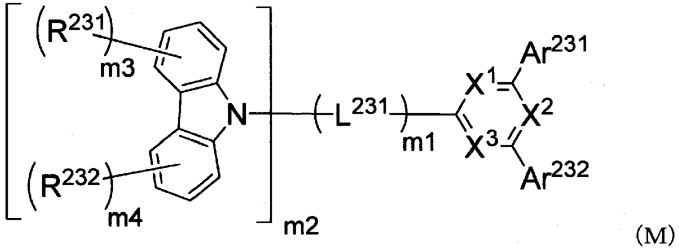

In the formula (M), Ar²³¹ and Ar²³² are independently a substituted or unsubstituted aryl group including 6 to 50 ring carbon atoms or a substituted or unsubstituted heteroaryl group including 5 to 50 ring carbon atoms.

R²³¹ and R²³² are independently a substituent. When two or more R²³¹ are present, two or more R²³¹ may be the same or different. When two or more R²³² are present, two or more R²³² may be the same or different.

X¹ to X³ are independently N, CH or C(R²³³), and at least two of X¹ to X³ are N.

R²³³ is a substituent, and when two or more R²³³ are present, two or more R²³³ may be the same or different.

L²³¹ is a substituted or unsubstituted arylene group including 6 to 18 ring carbon atoms, or a substituted or unsubstituted heteroarylene group including 5 to 15 ring carbon atoms, and when two or more L²³¹ are present, two or more L²³¹ may be the same or different.

m1 is an integer of 0 to 3.

m2 is an integer of 1 to 5.

m3 and m4 are independently an integer of 0 to 4.

Examples of the heteroaryl group including 6 to 50 ring carbon atoms and the heteroaryl group including 5 to 50 ring carbon atoms of Ar²³¹ and Ar²³² include the same as the aryl group including 6 to 50 ring carbon atoms and the heteroaryl group including 5 to 50 ring carbon atoms of Ar²¹ to Ar²⁴.

Examples of the arylene group including 6 to 18 ring carbon atoms and the heteroarylene group including 5 to 15 ring carbon atoms of L²³¹ include the same as the arylene group including 6 to 18 ring carbon atoms and the heteroarylene groups including 5 to 15 ring carbon atoms of L²¹ and L²².

When two or more R²³¹ are present, adjacent R²³¹ may be bonded with each other to form a ring. When two or more R²³² are present, adjacent R²³² may be bonded with each other to form a ring.

Examples of the substituent of R²³¹ to R²³³ include the groups listed for the formula (1). These substituents may further be substituted by the same substituent.

Examples of the substituent in "substituted or unsubstituted..." include the groups listed for the formula (1). These substituents may further be substituted by the same substituent. A plurality of these substituents may be bonded with each other to form a ring.

The compound represented by the formula (M) can be synthesized by known methods.

Specific examples of the compound comprising a carbazole ring and a nitrogen-containing six-membered ring and the compound represented by the formula (M) include the following compounds.

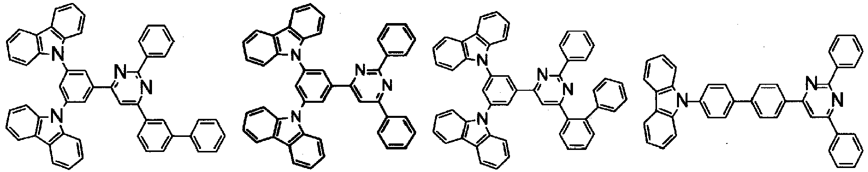

The electron-transporting material is mainly a material having an electron mobility of 10⁻⁶ cm²/Vs or more. Any material having the higher electron-transporting property than the hole-transporting property may be used for the electron-transporting layer. The electron-transporting layer may be a single layer or a laminate of two or more layers.

### (Electron-injecting layer)

The electron-injecting layer is a layer comprising a material having high electron-injecting property. As the electron-injecting layer, an alkali metal, an alkaline earth metal, or a compound thereof, such as lithium (Li), cesium (Cs), calcium (Ca), lithium fluoride (LiF), cesium fluoride (CsF), calcium fluoride (CaF₂), lithium oxide (LiOx), can be used. Alternatively, an electron-transporting material comprising an alkali metal, an alkaline earth metal, or a compound thereof, specifically, an Alq comprising magnesium (Mg) or the like may be used. In this case, the electron-injection from the cathode can be performed more efficiently.

Alternatively, a complex material in which an organic compound and an electron donor are mixed may be used for the electron-injecting layer. Such a complex material has excellent electron-injecting property and electron-transporting property because the organic compound receives electrons from the electron donor. As the organic compound, it is preferable to use a material excellent in transporting the received electrons, and specifically, for example, a material constituting the above electron-transporting layer (a metal complex, a heteroaromatic compound, or the like) can be used. The electron donor may be any material which exhibits electron-donating property to the organic compound. Specifically, an alkali metal, an alkaline earth metal, and a rare earth metal are preferable, and lithium, cesium, magnesium, calcium, erbium, ytterbium, and the like can be given. Alkali metal oxides and alkaline earth metal oxides are preferable, and lithium oxides, calcium oxides, barium oxides, and the like can be given. Lewis bases such as magnesium oxide can also be used. Alternatively, an organic compound such as tetrathiafulvalene (abbreviation: TTF) can be used.

### (Cathode)

For the cathode, a metal, an alloy, an electrically conductive compound, a mixture thereof, or the like, having a small work function (specifically, 3.8 eV or less) is preferably used. Specific examples of such a cathode material include elements belonging to Group 1 or Group 2 of the Periodic Table of the Elements, i.e., alkali metals such as lithium (Li) and cesium (Cs), alkaline earth metals such as magnesium (Mg), calcium (Ca) and strontium (Sr), and alloys containing these metals (e.g., MgAg and AILi); rare earth metals such as europium (Eu) and ytterbium (Yb), and alloys containing these metals.

When the cathode is formed using alkali metals, alkaline earth metals, or alloys containing these metals, a vacuum evaporation method or a sputtering method can be used. When a silver paste or the like is used, a coating method, an inkjet method, or the like can be used.

By providing the electron-injecting layer, a cathode can be formed using a variety of conductive material such as Al, Ag, ITO, graphene, silicon, or indium-tin oxide comprising silicon oxide regardless of the magnitude of the work function. The conductive material can be formed into a film by a sputtering method, an ink-jet method, a spin-coating method, or the like.

### (Substrates, etc.)

In order to efficiently emit light, it is preferable that at least one surface of the organic EL device be sufficiently transparent in the emission wavelength region of the device. It is also preferable that the substrate be transparent. The transparent electrodes are configured so as to ensure predetermined transparency by vapor deposition, sputtering, or the like using the above conductive material. The light transmittance of the electrode on the light emitting surface is preferably 10% or more.

As the substrate, glass, quartz, plastics or the like can be used, for example. Further, a flexible substrate may be used. The term "flexible substrate" means a bendable (flexible) substrate, and specific examples thereof include a plastic substrate formed of polycarbonate or polyvinyl chloride.

### (Method for forming each layer, etc.)

For the formation of each layer of the organic EL device, any of a dry film deposition method such as vacuum evaporation, sputtering, plasma, ion plating, and a wet film deposition method such as spin coating, dipping, flow coating, or the like can be applied.

The film thickness of each layer is not particularly limited, but it is necessary to configure an appropriate film thickness. If the film thickness is too thick, a large applied voltage is required to obtain a constant light output, and the efficiency may deteriorate. If the film thickness is too thin, a pinhole or the like is generated, and there is a possibility that sufficient emitting radiance cannot be obtained even if an electric field is applied. The film thickness is usually preferably from 1 nm to 10 µm, and may be from 5 nm to 0.2 µm. In either organic layer, appropriate resins or additives may be used to improve film forming properties, prevent pinholes in the film, and the like.

### [Other embodiments of organic EL device]

The organic EL device according to an aspect of the invention may be a bottom emission type (FIG. 1) in which light is taken out from the substrate side, or a top emission type in which light is taken out from the cathode side. The case where an organic EL device according to an aspect of the invention is a top emission type will be described below.

When the top emission type is adopted, the emitting unit portion sandwiched between the anode and the cathode (the emitting unit 10 in FIG. 1) can have the same configuration as the bottom emission type.

The anode and the cathode are as follows.

### (Anode)

The material of the anode is preferably a metal such as Ag, Al, Au or a metal alloy such as APC (Ag-Pd-Cu). These metal material and metal alloys may be laminated. Further, transparent electrodes such as indium tin oxide (ITO) or indium zinc oxide may be formed on the upper surface and/or the lower surface of a metal, a metal alloy, or a laminated structure thereof.

### (Cathode)

Metallic materials can be used as the cathode. Metallic material is a material having negative value in the real part of the dielectric constant. Such a material includes not only a metal but also an organic transparent electrode material and an inorganic transparent electrode material exhibiting a metallic luster other than a metal.

The metal is preferably Ag, Mg, Al, Ca, or the like, or an alloy thereof. In addition, it is preferable that the transmittance in the front direction be 20% or more and be translucent. When Ag, Mg, Al, Ca or alloys thereof are used as the cathode, the film thickness is preferably 30 nm or less in order to exhibit adequate light-transmittance.

When the top emission type is adopted, a capping layer may be provided on the upper portion of the cathode. By providing the capping layer, the peak intensity and the peak wavelength of light emission can be adjusted.

The compound which can be used for the capping layer is compound in which the molecular formula comprises a carbon atom and a hydrogen atom as constituent elements, and may comprise an oxygen atom, a nitrogen atom, a fluorine atom, a silicon atom, a chlorine atom, a bromine atom, and an iodine atom, and which may comprise a substituent.

Preferable examples of the material include the following compounds.
(i) An aromatic hydrocarbon compound in which the molecular formula comprises a carbon atom and a hydrogen atom as constituent elements, and may comprise an oxygen atom, a nitrogen atom, a fluorine atom, a silicon atom, a chlorine atom, a bromine atom, and an iodine atom, and may also comprise a substituent.
(ii) An aromatic heterocyclic compound in which the molecular formula comprises a carbon atom and a hydrogen atom as constituent elements, and may comprise an oxygen atom, a nitrogen atom, a fluorine atom, a silicon atom, a chlorine atom, a bromine atom, and an iodine atom, and may comprise a substituent
(iii) An amine compound in which the molecular formula comprises a carbon atom and a hydrogen atom as constituent elements, and may comprise an oxygen atom, a nitrogen atom, a fluorine atom, a silicon atom, a chlorine atom, a bromine atom, and an iodine atom, and may comprise a substituent.

The film thickness of the capping layer is preferably 200 nm or less, more preferably 20 nm or more and 200 nm or less, and still more preferably 40 nm or more and 140 nm or less.

FIG. 2 shows a schematic configuration of an organic EL device provided with a capping layer.

The organic EL device 100 includes an anode 3, an emitting unit 10, a cathode 4, and a capping layer 20 on a substrate 2 in this order to take out light from the capping layer 20 side. The emitting unit 10 is as described in FIG. 1.

### [Electronic appliance]

The organic EL device in an aspect of the invention can be used for planar light emitters such as flat panel displays of wall-mounted TVs, light sources such as copiers, printers, liquid crystal display backlights or instruments, display boards, sign lights, and the like. In addition, the compound in an aspect of the invention can be used not only in an organic EL device but also in the fields of electron photographic photoreceptors, photoelectric converters, photovoltaic cells, image sensors, and the like.

### Examples

### Example 1

### [Manufacture of bottom emission type organic EL device]

A 25 mm x 75 mm x 1.1 mm-thick glass substrate with ITO transparent electrode (anode) was subjected to ultrasonic cleaning in isopropyl alcohol for 5 minutes, followed by UV (ultraviolet) ozone washing for 30 minutes. The thickness of the ITO transparent electrode was 130 nm. The glass substrate with the transparent electrode line after being cleaned was mounted onto a substrate holder in a vacuum vapor deposition apparatus, and a compound HI-1 was deposited on a surface on the side on which the transparent electrode line was formed so as to cover the transparent electrode to form a hole-injecting layer having a thickness of 5 nm. Subsequent to the formation of the hole-injecting layer, a compound 1 was deposited thereon to form a first hole-transporting layer having a thickness of 90 nm. Subsequent to the formation of the first hole-transporting layer, a compound 4 was deposited thereon to form a second hole-transporting layer having a thickness of 10 nm. A compound BH-1 (a host material) and a compound BD-1 (a dopant material) were co-deposited on the second hole-transporting layer to be 4 mass% in a proportion (mass ratio) of the compound BD-1, thereby forming an emitting layer having a thickness of 20 nm. A compound 6 was deposited on the emitting layer to form a first electron-transporting layer having a thickness of 5 nm. A compound 7 was deposited on the first electron-transporting layer to form a second electron-transporting layer having a thickness of 20 nm. LiF was deposited on the second electron-transporting layer to form an electron-injecting layer having a thickness of 1 nm. A metal Al was deposited on the electron-injecting layer to form a cathode having a thickness of 80 nm.

As described above, an organic EL device was manufactured.

The compounds used in Example 1 and Examples and Comparative Examples described later are shown below.

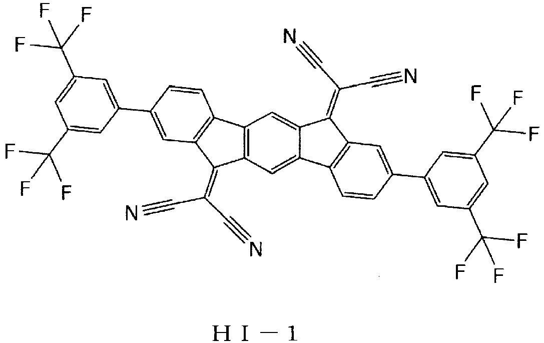

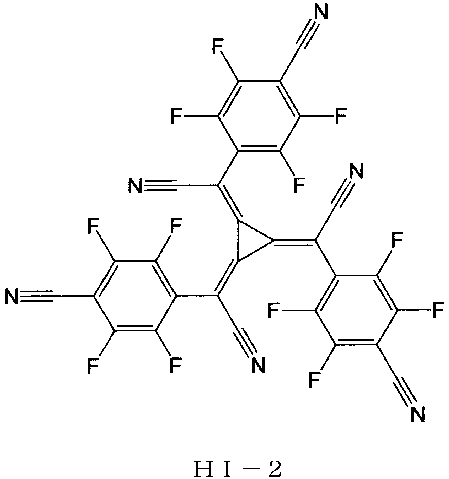

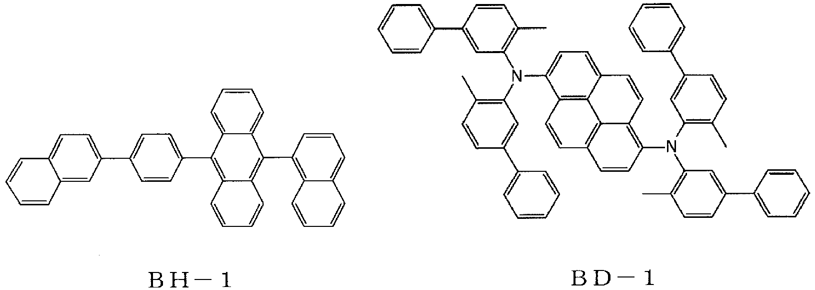

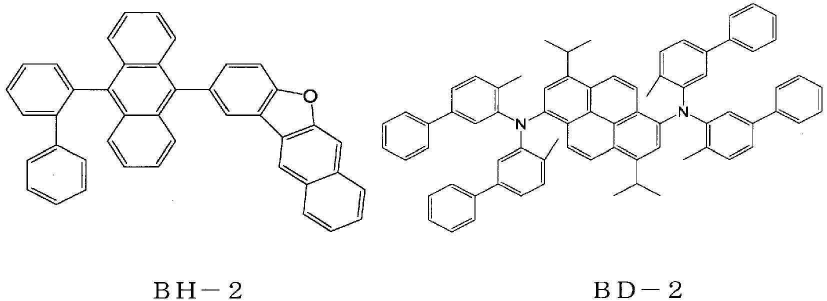

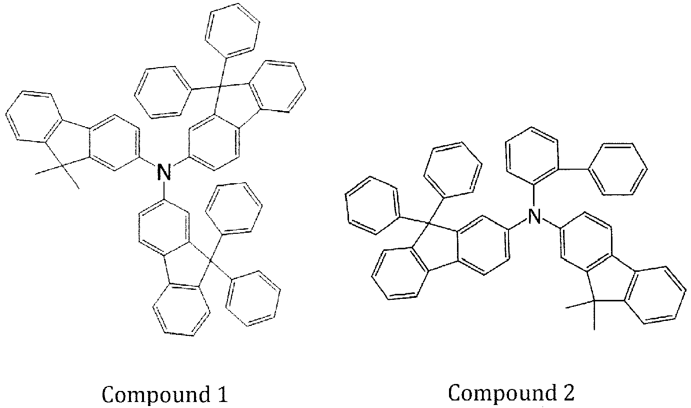

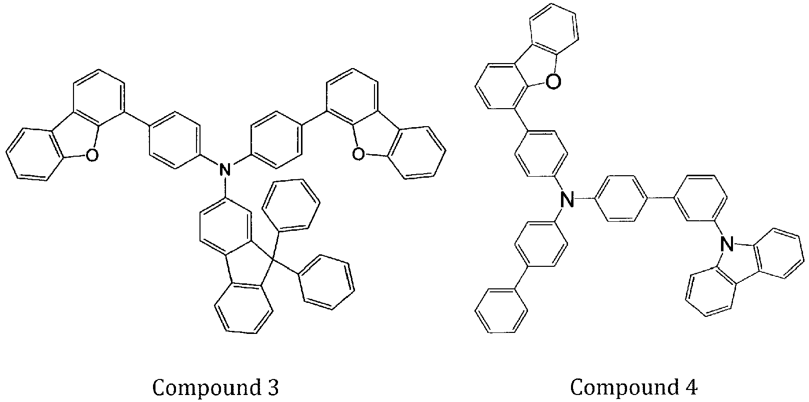

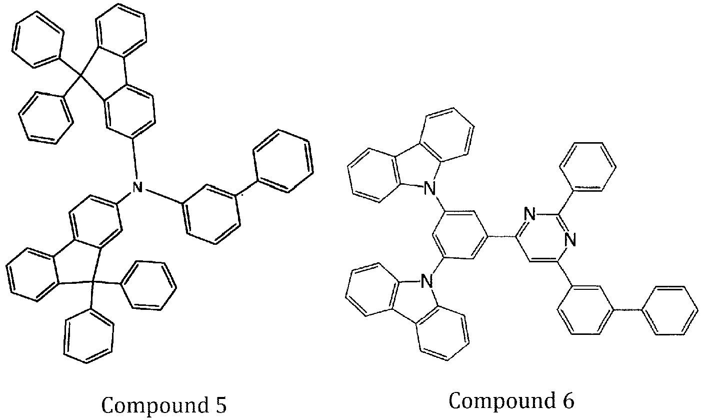

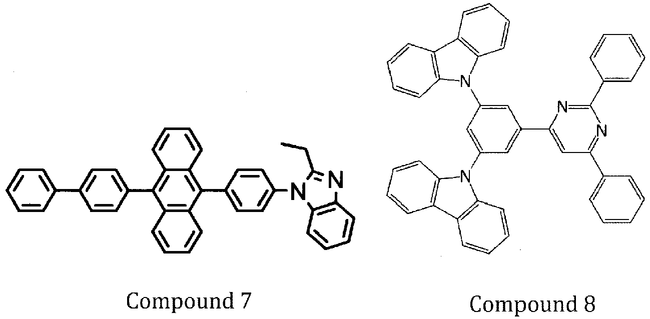

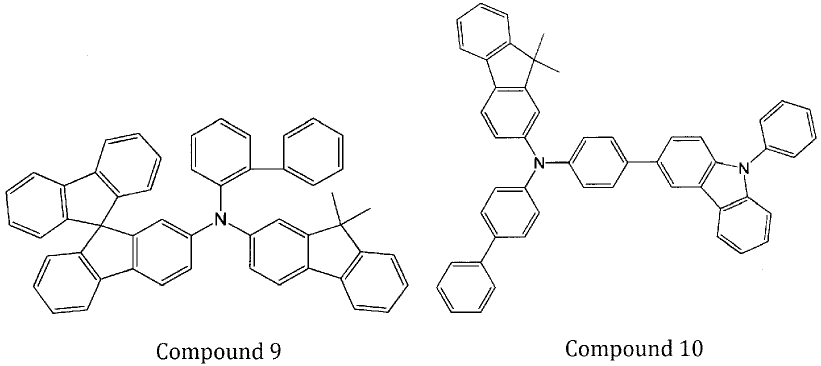

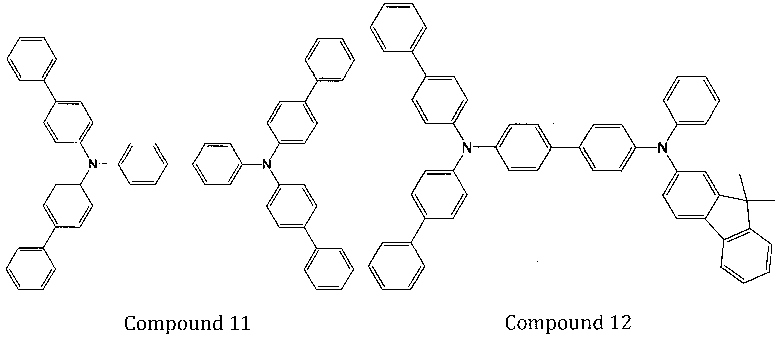

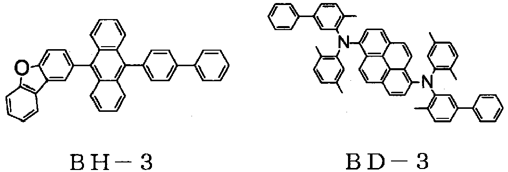

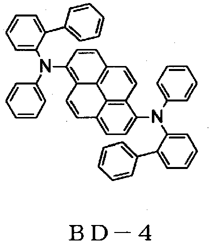

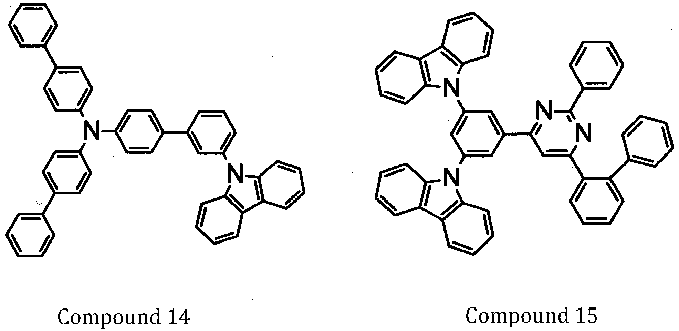

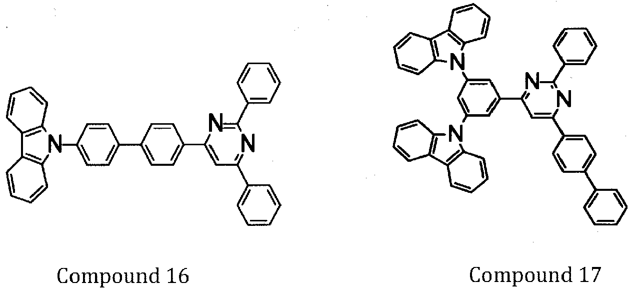

### [Evaluation of organic EL device]

A current efficiency and a device lifetime (LT95) of the obtained organic EL device were measured as follows. The results are shown in Table 1.

### (Current efficiency)

The spectral radiance spectrum when the voltage was applied to the organic EL device so that the current density to be 10 mA/cm² was measured by a spectroradiance meter (CS-1000 manufactured by Konica Minolta, Inc.), and the current efficiency (units: cd/A) was calculated from the obtained spectral radiance spectrum.

### (Device lifetime (LT95))

A voltage was applied to the organic EL device to be 50 mA/cm² in current density, and the time (units: h) until the luminance became 95% of the initial luminance was measured.

### Examples 2 to 7 and Comparative Example 1

### [Manufacturing and evaluation of bottom emission type organic EL devices]

Organic EL devices were manufactured and evaluated in the same manner as in Example 1 except that the materials of the hole-injecting layer, the first hole-transporting layer, the second hole-transporting layer, the emitting layer, the first electron-transporting layer and the second electron-transporting layer were changed as described in Table 1. The results are shown in Table 1.

In Example 2, a compound 7 and 8-hydroxyquinolinolato-lithium (Liq) were co-deposited to be 50 mass% in a proportion of Liq to form a second electron-transporting layer having a thickness of 20 nm.

In Example 4, a compound 9 and a compound HI-2 were co-deposited to be 3 mass% in a proportion of the compound HI-2 to form a hole-injecting layer having a thickness of 5 nm.

In Example 5, a compound 10 and a compound HI-2 were co-deposited to be 3 mass% in a proportion of the compound HI-2 to form a hole-injecting layer having a thickness of 5 nm.

In Example 6, a compound 11 and a compound HI-2 were co-deposited to be 3 mass% in a proportion of the compound HI-2 to form a hole-injecting layer having a thickness of 5 nm.

In Example 7, a compound BH-2 (a host material) and a compound BD-2 (a dopant material) were co-deposited to be 4 mass% in a proportion of the BD-2 to form an emitting layer having a thickness of 20 nm.

### Examples 8 to 28 and Comparative Examples 2 to 3

### [Manufacturing and evaluation of bottom emission type organic EL devices]

Organic EL devices were manufactured and evaluated in the same manner as in Example 1 except that the materials of the hole-injecting layer, the first hole-transporting layer, the second hole-transporting layer, the emitting layer, the first electron-transporting layer and the second electron-transporting layer were changed as described in Table 1. The results are shown in Table 1.

In Examples 8 to 28 and Comparative Examples 2 to 3, a host material and a dopant material were co-deposited to be 4 mass% in a proportion of the dopant material.

In Example 8, a compound 1 and a compound HI-2 were co-deposited to be 3 mass% in a proportion of the compound HI-2 to form a hole-injecting layer having a thickness of 5 nm.

In Example 9, a compound 2 and a compound HI-2 were co-deposited to be 3 mass% in a proportion of the compound HI-2 to form a hole-injecting layer having a thickness of 5 nm. Further, a compound 7 and 8-hydroxyquinolinolato-lithium (Liq) were co-deposited to be 50 mass% in a proportion of Liq to form a second electron-transporting layer having a thickness of 20 nm.

In Example 10, a compound 2 and a compound HI-2 were co-deposited to be 3 mass% in a proportion of the compound HI-2 to form a hole-injecting layer having a thickness of 5 nm.

In Example 11, a compound 3 and a compound HI-2 were co-deposited to be 3 mass% in a proportion of the compound HI-2 to form a hole-injecting layer having a thickness of 5 nm.

In Example 12, a compound 1 and a compound HI-2 were co-deposited to be 3 mass% in a proportion of the compound HI-2 to form a hole-injecting layer having a thickness of 5 nm.

In Example 13, a compound 2 and a compound HI-2 were co-deposited to be 3 mass% in a proportion of the compound HI-2 to form a hole-injecting layer having a thickness of 5 nm.

In Example 14, a compound 3 and a compound HI-2 were co-deposited to be 3 mass% in a proportion of the compound HI-2 to form a hole-injecting layer having a thickness of 5 nm.

In Example 15, a compound 3 and a compound HI-2 were co-deposited to be 3 mass% in a proportion of the compound HI-2 to form a hole-injecting layer having a thickness of 5 nm.

In Example 16, a compound 3 and a compound HI-2 were co-deposited to be 3 mass% in a proportion of the compound HI-2 to form a hole-injecting layer having a thickness of 5 nm.

In Example 17, a compound 3 and a compound HI-2 were co-deposited to be 3 mass% in a proportion of the compound HI-2 to form a hole-injecting layer having a thickness of 5 nm.

In Example 18, a compound 1 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 19, a compound 2 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 20, a compound 10 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 21, a compound 1 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 22, a compound 2 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 23, a compound 10 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 24, a compound 1 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 25, a compound 2 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 26, a compound 10 and a compound HI-2 were co-deposited to be 3 mass% in a proportion of the compound HI-2 to form a hole-injecting layer having a thickness of 5 nm. Further, a compound 17 and Liq were co-deposited to be 50 mass% in a proportion of Liq to form a second electron-transporting layer having a thickness of 20 nm.

In Example 27, a compound 3 and a compound HI-2 were co-deposited to be 3 mass% in a proportion of the compound HI-2 to form a hole-injecting layer having a thickness of 5 nm. The thickness of the second hole-transporting layer was 5 nm.

In Example 28, a compound 1 and a compound HI-2 were co-deposited to be 3 mass% in a proportion of the compound HI-2 to form a hole-injecting layer having a thickness of 5 nm. The thickness of the second hole-transporting layer was 5 nm. Further, a compound 17 and Liq were co-deposited to be 50 mass% in a proportion of Liq to form a second electron-transporting layer having a thickness of 20 nm.

In Examples 11, 21, 27, and 28, the voltage (units: V) was measured when a voltage was applied to the obtained organic EL device so that the current density became 10 mA/cm². The results are shown in Table 1.

The organic EL devices of Examples 11, 21, 27 and 28, in particular Examples 27 and 28, had a low driving voltage.

**Table 1**

| | Hole-injecting layer | First hole-transporting layer | Second hole-transporting layer | Emitting layer | | First electron-transporting layer | Second electron-transporting layer | Voltage (V) | Current efficiency (cd/A) | LT95 (h) |
|---|---|---|---|---|---|---|---|---|---|---|
| Example 1 | HI-1 | Compound 1 | Compound 4 | BH-1 | BD-1 | Compound 6 | Compound 7 | - | 10.2 | 83 |
| Example 2 | HI-1 | Compound 2 | Compound 4 | BH-1 | BD-1 | Compound 6 | Compound 7, Liq | - | 10.4 | 84 |
| Example 3 | HI-1 | Compound 3 | Compound 4 | BH-1 | BD-1 | Compound 8 | Compound 7 | - | 9.6 | 78 |
| Example 4 | Compound 9, HI-2 | Compound 9 | Compound 4 | BH-1 | BD-1 | Compound 6 | Compound 7 | - | 10.3 | 114 |
| Example 5 | Compound 10, HI-2 | Compound 10 | Compound 4 | BH-1 | BD-1 | Compound 6 | Compound 7 | - | 9.6 | 94 |
| Example 6 | Compound 11, HI-2 | Compound 11 | Compound 4 | BH-1 | BD-1 | Compound 8 | Compound 7 | - | 10.0 | 107 |
| Example 7 | HI-1 | Compound 12 | Compound 4 | BH-2 | BD-2 | Compound 8 | Compound 7 | - | 11.0 | 55 |
| Example 8 | Compound 1, HI-2 | Compound 1 | Compound 4 | BH-1 | BD-1 | Compound 6 | Compound 7 | - | 10.0 | 87 |
| Example 9 | Compound 2, HI-2 | Compound 2 | Example Compound 4 | BH-1 | BD-1 | Compound 6 | Compound 7, Liq | - | 10.3 | 92 |
| Example 10 | Compound 2, HI-2 | Compound 2 | Compound 4 | BH-1 | BD-1 | Compound 6 | Compound 7 | - | 10.3 | 88 |
| Example 11 | Compound 3, HI-2 | Compound 3 | Compound 4 | BH-1 | BD-1 | Compound 8 | Compound 7 | 3.9 | 9.8 | 62 |
| Example 12 | Compound 1, HI-2 | Compound 1 | Compound 14 | BH-1 | BD-1 | Compound 6 | Compound 7 | - | 10.1 | 81 |
| Example 13 | Compound 2, HI-2 | Compound 2 | Compound 14 | BH-1 | BD-1 | Compound 6 | Compound 7 | - | 10.3 | 84 |
| Example 14 | Compound 3, HI-2 | Compound 3 | Compound 14 | BH-1 | BD-1 | Compound 8 | Compound 7 | - | 9.8 | 64 |
| Example 15 | Compound 3, HI-2 | Compound 3 | Compound 4 | BH-1 | BD-3 | Compound 8 | Compound 7 | - | 9.7 | 65 |
| Example 16 | Compound 3, HI-2 | Compound 3 | Compound 4 | BH-1 | BD-1 | Compound 15 | Compound 7 | - | 10.1 | 53 |
| Example 17 | Compound 3, HI-2 | Compound 3 | Compound 4 | BH-1 | BD-1 | Compound 16 | Compound 7 | - | 10.0 | 59 |
| Example 18 | Compound 1, HI-2 | Compound 1 | Compound 14 | BH-3 | BD-1 | Compound 8 | Compound 17, Liq | - | 9.8 | 79 |
| Example 19 | Compound 2, HI-2 | Compound 2 | Compound 14 | BH-3 | BD-1 | Compound 8 | Compound 17, Liq | - | 10.0 | 73 |
| Example 20 | Compound 10, HI-2 | Compound 10 | Compound 14 | BH-3 | BD-1 | Compound 8 | Compound 17, Liq | - | 9.8 | 73 |
| Example 21 | Compound 1, HI-2 | Compound 1 | Compound 14 | BH-3 | BD-1 | Compound 15 | Compound 17, Liq | 3.8 | 10.2 | 64 |
| Example 22 | Compound 2, HI-2 | Compound 2 | Compound 14 | BH-3 | BD-1 | Compound 15 | Compound 17, Liq | - | 10.4 | 64 |
| Example 23 | Compound 10, HI-2 | Compound 10 | Compound 14 | BH-3 | BD-1 | Compound 15 | Compound 17, Liq | - | 10.1 | 66 |
| Example 24 | Compound 1, HI-2 | Compound 1 | Compound 14 | BH-3 | BD-1 | Compound 16 | Compound 17, Liq | - | 10.0 | 74 |
| Example 25 | Compound 2, HI-2 | Compound 2 | Compound 14 | BH-3 | BD-1 | Compound 16 | Compound 17, Liq | - | 10.1 | 68 |
| Example 26 | Compound 10, HI-2 | Compound 10 | Compound 14 | BH-3 | BD-1 | Compound 16 | Compound 17, Liq | - | 9.9 | 72 |
| Example 27 | Compound 3, HI-2 | Compound 3 | Compound 4 | BH-1 | BD-1 | Compound 8 | Compound 7 | 3.7 | 9.8 | 71 |
| Example 28 | Compound 1, HI-2 | Compound 1 | Compound 14 | BH-3 | BD-1 | Compound 15 | Compound 17, Liq | 3.6 | 10.2 | 63 |
| Comp. Ex. 1 | HI-1 | Compound 1 | Compound 5 | BH-1 | BD-1 | Compound 6 | Compound 7 | - | 8.3 | 11 |
| Comp. Ex. 2 | Compound 3, HI-2 | Compound 3 | Compound 4 | BH-1 | BD-4 | Compound 8 | Compound 7 | - | 8.9 | 46 |

From Table 1, it was found that the organic EL device according to an aspect of the invention was highly efficient and had a long lifetime.

### Example 31

### [Manufacturing and evaluation of top emission type organic EL devices]

On the glass substrate, a layer of silver-alloy APC (Ag-Pd-Cu) (a reflective layer) (film thickness: 100 nm) and a layer of indium-zinc oxide (IZO) (film thickness: 10 nm) were formed in this order by a sputtering method. Subsequently, this conductive material layer was patterned by etching using a resist pattern as a mask by using a normal lithography technique to form an anode layer. The substrate on which the lower electrode was formed was subjected to ultrasonic cleaning in isopropyl alcohol for 5 minutes, followed by UV ozone cleaning for 30 minutes. Thereafter, a compound HI-1 was deposited by a vacuum deposition method to form a hole-injecting layer film having a thickness of 5 nm. The deposition of the hole-injecting layer was followed by a deposition of a compound 1 to form a first hole-transporting layer having a thickness of 130 nm. The deposition of the first hole-transporting layer was followed by a deposition of a compound 4 to form a second hole-transporting layer having a thickness of 10 nm. A compound BH-1 (a host material) and compound BD-1 (a dopant material) were co-deposited on the second hole-transporting layer to be 4 mass% in a proportion of BD-1 to form an emitting layer having a thickness of 20 nm. A compound 6 was deposited on the emitting layer to form a first electron-transporting layer having a thickness of 5 nm. A compound 7 was deposited on the first electron-transporting layer to form a second electron-transporting layer having a thickness of 20 nm. LiF was deposited on the second electron-transporting layer to form an electron-injecting layer having a thickness of 1 nm. On the electron-injecting layer, Mg and Ag were deposited in a thickness ratio of 1:9 to form a cathode made of semi-permeable MgAg alloys having a thickness of 15 nm. On the cathode, a compound 13 was deposited by a vacuum-deposition method to form a capping layer having a thickness of 65 nm.

As described above, an organic EL device was manufactured. The compound 13 used for the capping layers is shown below.

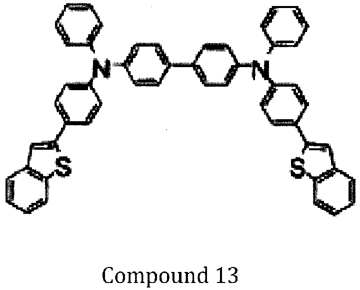

As a result of evaluating the obtained organic EL device in the same manner as in Example 1, the current efficiency was 8.4 cd/A and LT95 was 58 hours.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification are incorporated herein by reference in its entirety.

## Claims

1. An organic electroluminescence device, comprising:
an anode,
an organic layer,
an emitting layer, and
a cathode in this order,
wherein the organic layer comprises a compound represented by the following formula (20), and
the emitting layer comprises a compound represented by the following formula (1): 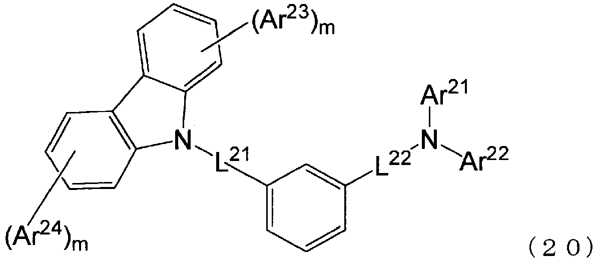
wherein in the formula (20), Ar²¹ to Ar²⁴ are independently a substituted or unsubstituted aryl group including 6 to 50 ring carbon atoms or a substituted or unsubstituted heteroaryl group including 5 to 50 ring carbon atoms,
m is an integer of 0 to 4,
L²¹ and L²² are independently a single bond, a substituted or unsubstituted arylene group including 6 to 18 ring carbon atoms or a substituted or unsubstituted heteroarylene group including 5 to 15 ring carbon atoms,
when m is an integer of 2 or more, each Ar²³ may be the same or different, and each Ar²⁴ may be the same or different, 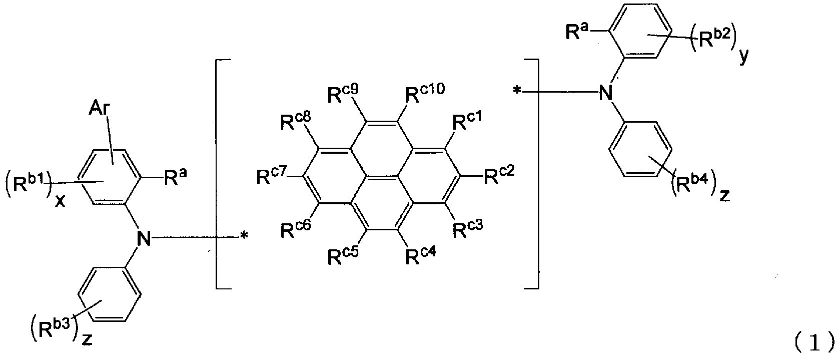
wherein in the formula (1), Ar is a substituted or unsubstituted aryl group including 6 to 30 ring carbon atoms,
R^{a} are independently a substituted or unsubstituted alkyl group including 1 to 15 carbon atoms, or a substituted or unsubstituted cyclic alkyl group including 3 to 15 carbon atoms,
R^{b1} to R^{b4} are independently a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, or a substituted or unsubstituted heteroaryl group including 3 to 30 ring atoms,
R^{c1} to R^{c10} are independently a hydrogen atom, a halogen atom, a cyano group, a substituted or unsubstituted alkyl group including 1 to 15 carbon atoms, a substituted or unsubstituted cyclic alkyl group including 3 to 15 carbon atoms, a substituted or unsubstituted alkylsilyl group including 1 to 45 carbon atoms, a substituted or unsubstituted arylsilyl group including 6 to 50 carbon atoms, a substituted or unsubstituted alkoxy group including 1 to 15 carbon atoms, a substituted or unsubstituted aryloxy group including 6 to 30 ring carbon atoms, a substituted or unsubstituted alkylthio group including 1 to 15 carbon atoms, a substituted or unsubstituted arylthio group including 6 to 30 ring carbon atoms, a substituted or unsubstituted arylamino group including 6 to 30 ring carbon atoms, a substituted or unsubstituted aryl group including 6 to 30 ring carbon atoms, a substituted or unsubstituted heteroaryl group including 3 to 30 ring atoms, or a single bond that bonds with a nitrogen atom,
* indicates the binding position between the nitrogen atom and any of R^{c1} to R^{c10},
x is an integer of 0 to 3,
y is an integer of 0 to 4,
z is independently an integer of 0 to 5,
when x is an integer of 2 or more, plural R^{b1} may be the same or different, when y is an integer of 2 or more, plural R^{b2} may be the same or different, when z is an integer of 2 or more, plural R^{b3} may be the same or different and plural R^{b4} may be the same or different.

2. The organic electroluminescence device according to claim 1, wherein the organic layer is directly adjacent to the emitting layer.

3. The organic electroluminescence device according to claim 1 or 2, comprising a hole-injecting layer between the organic layer and the anode, wherein the hole-injecting layer comprises a compound represented by the following formula (2-1): 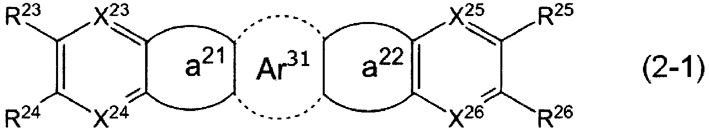
wherein in the formula (2-1), Ar³¹ is a substituted or unsubstituted aromatic hydrocarbon ring including 6 to 30 ring carbon atoms, or a substituted or unsubstituted aromatic heterocyclic ring including 5 to 30 ring atoms,
X²³ to X²⁶ are independently C(R) or a nitrogen atom,
a²¹ and a²² are independently a ring structure represented by the following formula (2b), 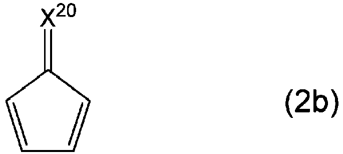 wherein in the formula (2b), X²⁰ is a structure represented by any of the following formula (2b-1) to (2b-12), 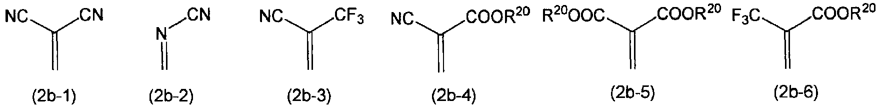 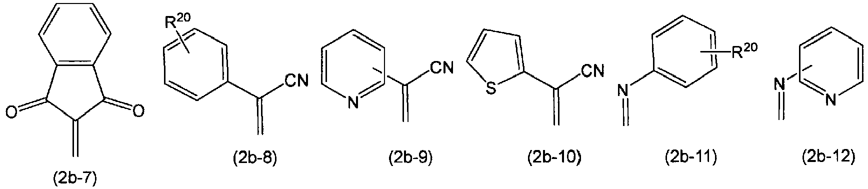 R, R²⁰ and R²³ to R²⁶ are independently a hydrogen atom, a halogen atom, a hydroxyl group, a cyano group, a substituted or unsubstituted alkyl group including 1 to 30 carbon atoms, a substituted or unsubstituted aryl group including 6 to 30 carbon atoms; a monosubstituted, disubstituted or trisubstituted silyl group having one or more substituents selected from the group consisting of a substituted or unsubstituted alkyl group including 1 to 30 carbon atoms, a substituted or unsubstituted aryl group including 6 to 30 ring carbon atoms; an alkoxy group having a substituted or unsubstituted alkyl group including 1 to 30 carbon atoms, an aryloxy group having a substituted or unsubstituted aryl group including 6 to 30 ring carbon atoms; a monosubstituted or disubstituted amino group having one or more substituents selected from the group consisting of a substituted or unsubstituted alkyl group including 1 to 30 carbon atoms and a substituted or unsubstituted aryl group including 6 to 30 ring carbon atoms; an alkylthio group having a substituted or unsubstituted alkyl group including 1 to 30 carbon atoms, an arylthio group having a substituted or unsubstituted aryl group including 6 to 30 ring carbon atoms, or a substituted or unsubstituted heteroaryl group including 5 to 30 ring atoms.

4. The organic electroluminescence device according to any one of claims 1 to 3, comprising an electron-transporting layer between the emitting layer and the cathode, wherein the electron-transporting layer comprises one or more compounds selected from the group consisting of an imidazole derivative, a benzimidazole derivative, an azine derivative, a carbazole derivative and a phenanthroline derivative.

5. The organic electroluminescence device according to any one of claims 1 to 4, comprising two or more electron-transporting layers between the emitting layer and the cathode.

6. The organic electroluminescence device according to claim 4 or 5, wherein the electron-transporting layer comprises a carbazole derivative, and
the carbazole derivative is a compound comprising a carbazole ring and a nitrogen-containing six-membered ring.

7. The organic electroluminescence device according to any one of claims 4 to 6, wherein the electron-transporting layer comprises a compound represented by the following formula (M): 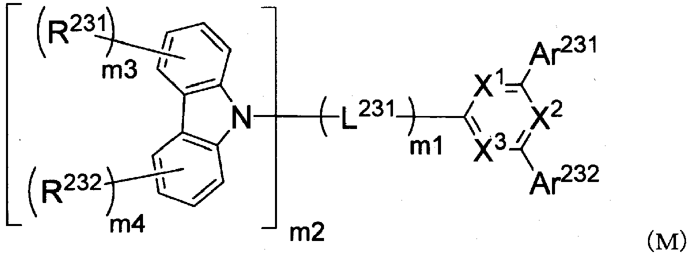
wherein in the formula (M), Ar²³¹ and Ar²³² are independently a substituted or unsubstituted aryl group including 6 to 50 ring carbon atoms, or a substituted or unsubstituted heteroaryl group including 5 to 50 ring carbon atoms,
R²³¹ and R²³² are independently a substituent,
when two or more R²³¹ are present, the two or more R²³¹ may be the same or different, and when two or more R²³² are present, the two or more R²³² may be the same or different,
X¹ to X³ are independently N, CH or C (R²³³), and at least two of X¹ to X³ are N,
R²³³ is a substituent, and when two or more R²³³ are present, the two or more R²³³ may be the same or different,
L²³¹ is a substituted or unsubstituted arylene group including 6 to 18 ring carbon atoms, or a substituted or unsubstituted heteroarylene group including 5 to 15 ring carbon atoms, and when two or more L²³¹ are present, the two or more L²³¹ may be the same or different,
m1 is an integer of 0 to 3,
m2 is an integer of 1 to 5, and
m3 and m4 are independently an integer of 0 to 4.

8. The organic electroluminescence device according to any one of claims 1 to 7, comprising a hole-transporting layer between the organic layer and the anode, wherein the hole-transporting layer comprises a compound represented by the following formula (J): 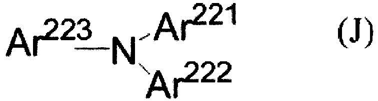
wherein in the formula (J), Ar²²¹ to Ar²²³ are independently a substituted or unsubstituted aryl group including 6 to 50 ring carbon atoms, a substituted or unsubstituted fused aryl group including 10 to 50 ring carbon atoms, a substituted or unsubstituted heteroaryl group including 5 to 50 ring atoms, a substituted or unsubstituted fused heteroaryl group including 8 to 50 ring atoms, or a group wherein the aryl group or the fused aryl group is bonded with the heteroaryl group or the heteroaryl group, and
Ar²²¹ and Ar²²², Ar²²² and Ar²²³, and Ar²²¹ and Ar²²³ may be bonded with each other to form a saturated or unsaturated ring structure.

9. The organic electroluminescence device according to any one of claims 1 to 8, wherein the compound represented by the formula (1) is a compound selected from the group consisting of the following compounds:

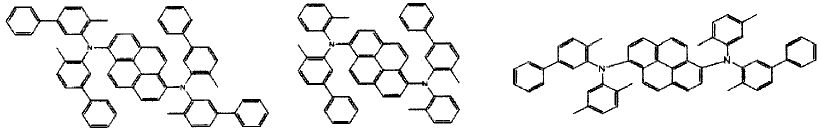

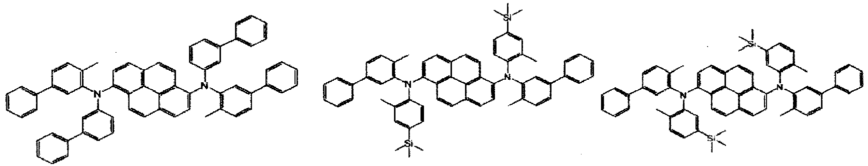

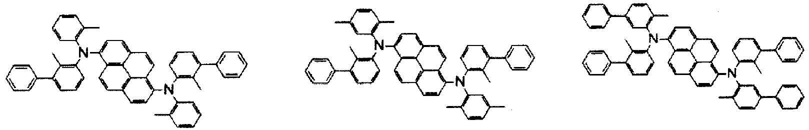

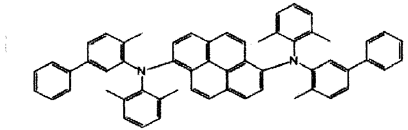

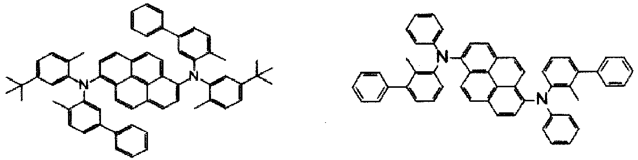

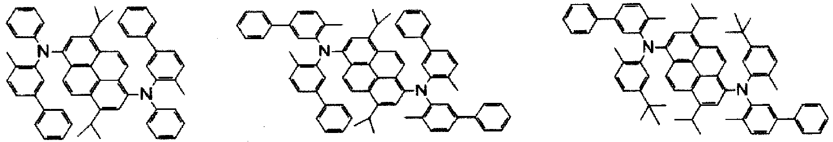

10. The organic electroluminescence device according to any one of claims 1 to 9, wherein the compound represented by the formula (20) is a compound selected from the group consisting of the following compounds:

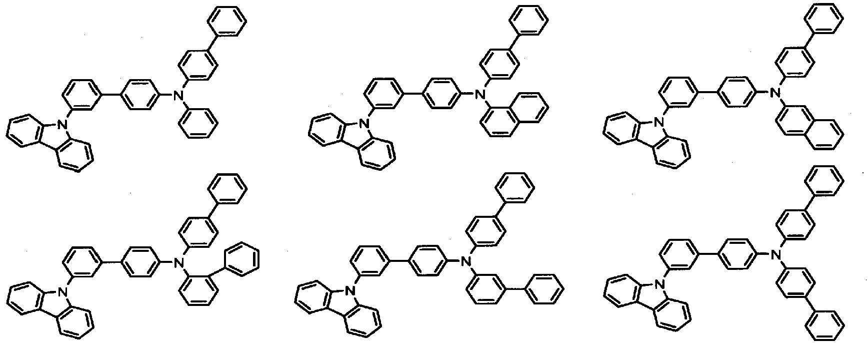

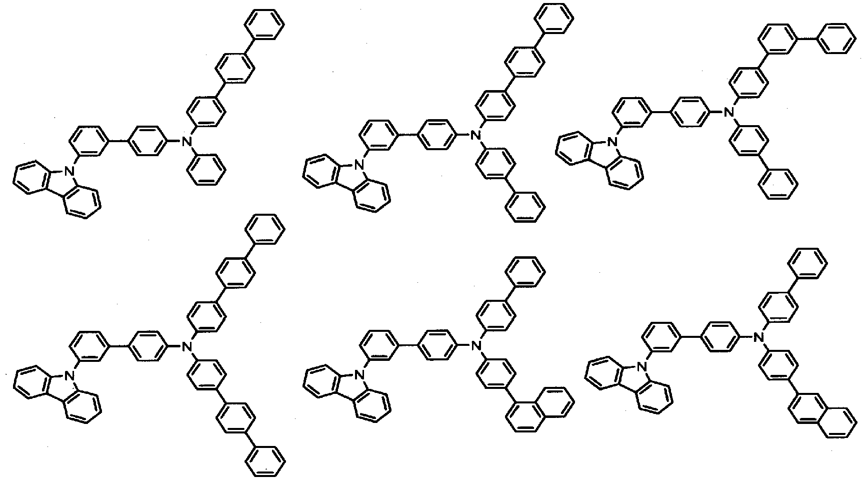

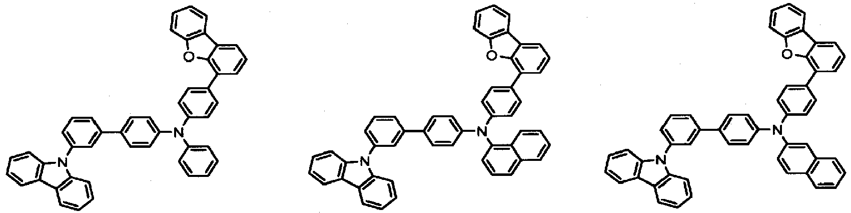

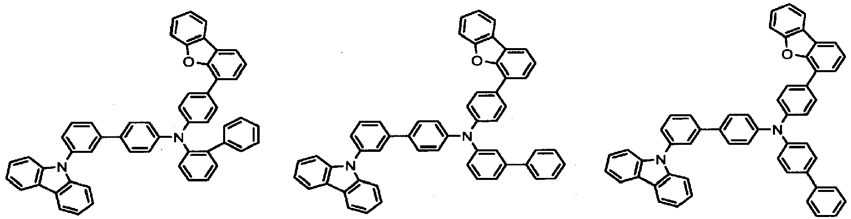

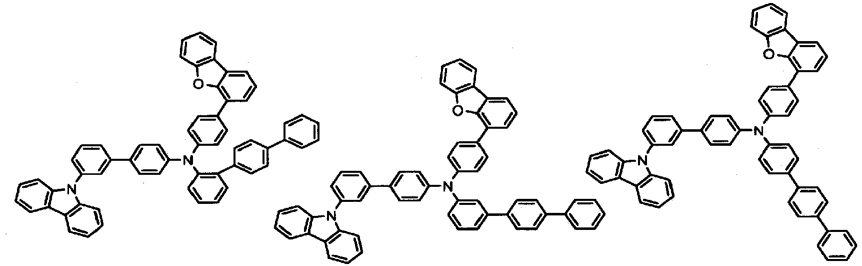

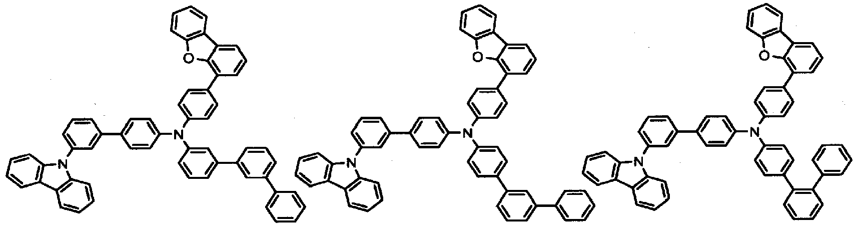

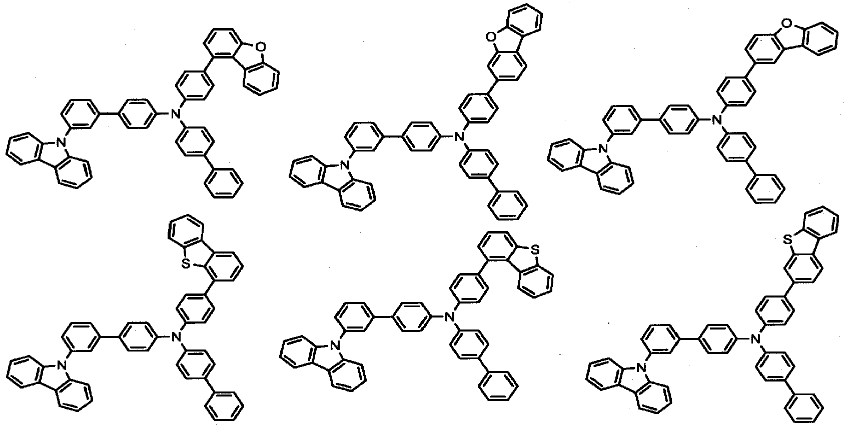

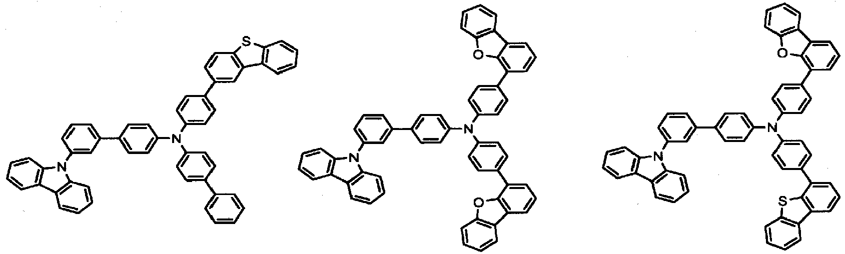

11. An electronic appliance, wherein the organic electroluminescence device according to any one of claims 1 to 10 is mounted.
